# EUROPÄISCHE PATENTSCHRIFT

(11) **EP 3 502 182 B1**
(45) Veröffentlichungstag und Bekanntmachung des Hinweises auf die Patenterteilung: **21.10.2020**
(21) Anmeldenummer: 17208724.9
(22) Anmeldetag: 20.12.2017
(51) Int. Cl.: C08L 69/00

(54) **STABILISIERTE, GEFÜLLTE POLYCARBONAT-ZUSAMMENSETZUNGEN**
STABILIZED, FILLED POLYCARBONATE COMPOSITIONS
COMPOSITIONS DE POLYCARBONATE CHARGÉES ET STABILISÉES

(43) Veröffentlichungstag der Anmeldung: 26.06.2019
(73) Patentinhaber: Covestro Deutschland AG, 51373 Leverkusen (DE)
(72) Erfinder: HUNGERLAND, Tim Dr., 51061 Köln (DE); CASSEL, Tanja, 47167 Duisburg (DE)
(74) Vertreter: Levpat

(56) Entgegenhaltungen:
- EP-A2- 0 332 454
- WO-A1-2010/108626
- DE-A1-102005 058 847

## Beschreibung

Die vorliegende Erfindung betrifft die Stabilisierung von aromatischem Polycarbonat in mit Oxiden von Metallen oder Halbmetallen der 3. oder 4. Hauptgruppe oder 4. Nebengruppe gefüllten Polycarbonatzusammensetzungen gegen den Molekulargewichtsabbau bei gleichzeitig möglichst geringer Beeinflussung der mechanischen Eigenschaften, insbesondere der Wärmeformbeständigkeit und entsprechend die Verwendung eines neuen Additives zu diesem Zweck sowie entsprechende Zusammensetzungen, enthaltend aromatisches Polycarbonat und mindestens ein Oxid eines Metalls oder Halbmetalls der 3. oder 4. Hauptgruppe oder 4. Nebengruppe und also auch ein Verfahren zur Vermeidung bzw. Reduzierung des Polycarbonat-Abbaus durch den Zusatz solcher Oxide. Die Erfindung betrifft außerdem Formteile aus diesen Zusammensetzungen.

Die Herstellung von gefüllten Polycarbonat-Zusammensetzungen durch Compoundierung führt unter den für das Material üblichen Prozessbedingungen, je nach Füllstoff, zu einem Molekulargewichtsabbau des Polycarbonates. Füllstoffe, besonders solche, die reaktive Gruppen an der Oberfläche tragen, können chemisch mit dem Polycarbonat reagieren. Diese Reaktionen können zu Kettenspaltung und somit zu Molekulargewichtsabbau führen. Dieses Problem ist u.a. in der US 2006/0287422 A1 beschrieben.

Der Molekulargewichtsabbau hat seinerseits einen negativen Einfluss auf die optischen, rheologischen, mechanischen und thermischen Eigenschaften der Polycarbonat-Zusammensetzungen. Es ist daher erforderlich, dass den Zusammensetzungen Prozessstabilisatoren zugesetzt werden, die den Abbau der Polymerketten, den Molekulargewichtsabbau, inhibieren.

Für die Stabilisierung von Polycarbonat gibt es mittlerweile vielfältig untersuchte Additive, die zumeist auf der antioxidativen Wirkung von Organophosphorverbindungen basieren. So wird zum Beispiel in der WO 2011/038842 A1 beschrieben, dass durch Zusatz von Phosphaten in geringen Mengen die Schmelzestabilität und somit der Molekulargewichtsabbau während der Verarbeitung von Polycarbonatzusammensetzungen verbessert werden kann. Die damit verbundene Vergilbung und somit die Verschlechterung der optischen Eigenschaften wird ebenfalls minimiert. Die DE 102009043513 A1 beschreibt Kombinationen von verschiedenen Organophosphorverbindungen zur Verbesserung der optischen Eigenschaften von Polycarbonatzusammensetzungen. Da das Funktionsprinzip jedoch auf Redox-Vorgängen beruht, lässt sich hiermit keine effektive Stabilisierung von Füllstoff-basierten Polycarbonat-Compounds realisieren.

Aus heutiger Sicht gibt es zwei Arten von Additiven, die dieser Art von Polymerabbau entgegenwirken können - anorganische Säuren, etwa beschrieben in WO 2013/060687 A1, wie z.B. Phosphorsäure oder phosphorige Säure. Zum anderen existieren organische Säuren (zumeist Carbonsäuren), wie z.B. Zitronensäure oder säurefunktionalisierte olefinische (Co)polymere, etwa beschrieben in der DE 102005058847 A1. Der Einsatz solcher Systeme in Polycarbonat-Zusammensetzungen ist jedoch mit Nachteilen verbunden. Die hohe Acidität der anorganischen Säuren kann bei zu hoher Dosierung ihrerseits zu einer Spaltung der Carbonateinheiten, und somit zum Abbau, führen. Organische Säuren zersetzen sich meist bereits weit unterhalb der üblichen Verarbeitungstemperatur von Polycarbonat (260-400°C). So zersetzt sich beispielsweise Zitronensäure ab 175°C. Klassische Polymere oder oligomere Systeme, die auf olefinischen Grundstrukturen basieren, die Carbonsäure- oder Carbonsäureanhydrid-Funktionalitäten tragen, führen hingegen, aufgrund ihrer vergleichbar niedrigen Viskosität, ab einer gewissen kritischen Konzentration zur Plastifizierung des Polycarbonats und somit zum teilweisen Verlust von mechanischen und thermischen Eigenschaften.

Aus den genannten Gründen ist es erstrebenswert, ein Additiv zu finden, welches sich sowohl unter den Verarbeitungsbedingungen von Polycarbonat nicht zersetzt, die mechanischen und thermischen Eigenschaften von Polycarbonat nicht negativ beeinträchtigt als auch eine ausreichende stabilisierende Wirkung, möglichst bereits in niedrigen Konzentrationen, besitzt.

Klassische Prozessstabilisatoren wie Phosphite oder Phosphonite haben sich als nicht geeignet erwiesen, um den Füllstoff-induzierten Abbau zu inhibieren. In gefüllten Thermoplasten kommen unter anderem oxidierte, Säure-modifizierte polyolefinische (Co)polymere, wie z.B. HiWax der Firma Mitsui Chemicals, oder A-C-Produkte der Firma Honeywell zum Einsatz. Die WO 2016/087477 A1 beschreibt den Einsatz von oxidierten Polyethylen-Wachsen in Polycarbonat und deren Einfluss, unter anderem auf die Wärmeformbeständigkeit. Bereits geringe Mengen dieser Additive können aufgrund ihrer niedrigen Schmelzpunkte die thermischen sowie mechanischen Eigenschaften negativ beeinflussen. Zur Stabilisierung von gefüllten Polycarbonatzusammensetzungen sind, je nach Füllstoffgehalt, Wachskonzentrationen > 1 Gew.-% nötig. In höheren Konzentrationen haben solche Additive allerdings eine weichmachende Wirkung und schmälern dadurch die verstärkende Wirkung des Füllstoffes und somit dessen primäres Ziel. Zusätzlich nimmt die Mischbarkeit dieser olefinischen Wachse mit Polycarbonat mit steigendem Gehalt schnell ab, was zu einer starken Eintrübung der Compounds führt. Zudem wirkt sich dies auch bei Zugabe von Füllstoffen negativ auf die Einfärbbarkeit aus und führt zu Delaminationseffekten an der Oberfläche der Materialien. Des Weiteren ist die Stabilität solcher Wachse unter längerer thermischer Belastung nicht gegeben, was zu einer schnelleren Vergilbung des Materials führt.

Aufgabe war es daher, geeignete neuartige Stabilisatoren, die einen Molekulargewichtsabbau bei aromatischem Polycarbonat in mit Metall/Halbmetalloxid-gefüllten Polycarbonat-Zusammensetzungen inhibieren und sich dabei nicht negativ auf die eigentliche Verstärkungswirkung des Füllstoffes auswirken, zu identifizieren und entsprechende Zusammensetzungen bereitzustellen. Dabei sollten sich die thermischen, mechanischen, optischen und rheologischen Eigenschaften der Polycarbonat-Zusammensetzungen, verglichen mit Zusammensetzungen ohne den neuartigen Stabilisator, möglichst wenig, am besten gar nicht negativ verändern.

Überraschend wird diese Aufgabe gelöst durch den Zusatz von PMMI-Copolymer zu den Polycarbonat-Zusammensetzungen. Durch den Zusatz des PMMI-Copolymers werden die Wärmeformbeständigkeit sowie die mechanischen und rheologischen Eigenschaften der Polycarbonat-Zusammensetzungen nicht signifikant verschlechtert, sondern in einigen Fällen sogar noch verbessert.

Gegenstand der Erfindung ist somit die Verwendung von PMMI-Copolymeren zur Inhibierung, d.h. mindestens Reduzierung, bevorzugt Vermeidung des Molekulargewichtsabbau von aromatischem Polycarbonat in mit mindestens einem Oxid eines Metalls oder Halbmetalls der 3. oder 4. Hauptgruppe oder 4. Nebengruppe gefüllten, Polycarbonat-Zusammensetzungen beim Compoundieren, insbesondere auch beim Compoundieren mittels Ko-Kneter. Ko-Kneter haben üblicherweise vergleichsweise hohe Verweilzeiten, so dass eine gute Stabilisierung hier von besonderer Bedeutung ist.

Compoundieren ist das Beimischen von Zuschlagstoffen, insbesondere von Füllstoffen und Additiven, zu dem Kunststoff, hier: zu dem aromatischen Polycarbonat. Dies geschieht üblicherweise mittels eines Extruders und bei Temperaturen im Extruder oberhalb von 260°C.

Gegenstand der Erfindung ist folglich auch eine Zusammensetzung, enthaltend
A) aromatisches Polycarbonat,
B) mindestens ein Oxid eines Metalls oder Halbmetalls der 3. oder 4. Hauptgruppe oder 4. Nebengruppe, insbesondere Titandioxid, Siliciumdioxid und/oder Aluminiumoxid,
C) PMMI-Copolymer und
D) optional weitere Additive.

"Mindestens ein Oxid eines Metalls oder Halbmetalls der 3. oder 4. Hauptgruppe oder 4. Nebengruppe" ist gleichbedeutend mit "ein oder mehrere Oxide eines Metalls oder Halbmetalls der 3. Hauptgruppe, 4. Hauptgruppe und/oder 4. Nebengruppe".

Die einzelnen Komponenten sind nachfolgend näher beschrieben.

### Komponente A

Komponente A der Zusammensetzungen sind aromatische Polycarbonate.

Aromatische Polycarbonate im Sinne der vorliegenden Erfindung sind sowohl Homopolycarbonate als auch Copolycarbonate und/oder Polyestercarbonate; die Polycarbonate können in bekannter Weise linear oder verzweigt sein. Erfindungsgemäß können auch Mischungen von Polycarbonaten verwendet werden.

Die thermoplastischen Polycarbonate einschließlich der thermoplastischen, aromatischen Polyestercarbonate haben bevorzugt gewichtsmittlere Molekulargewichte M_{w} von 15.000 g/mol bis 40.000 g/mol, weiter bevorzugt bis 34.000 g/mol, besonders bevorzugt von 17.000 g/mol bis 33.000 g/mol, insbesondere von 19.000 g/mol bis 32.000 g/mol, ermittelt durch Gelpermeationschromotographie, kalibriert gegen Bisphenol A-Polycarbonat Standards unter Verwendung von Dichlormethan als Elutionsmittel, Kalibrierung mit linearen Polycarbonaten (aus Bisphenol A und Phosgen) bekannter Molmassenverteilung der PSS Polymer Standards Service GmbH, Deutschland, Kalibrierung nach der Methode 2301-0257502-09D (aus dem Jahre 2009 in deutscher Sprache) der Currenta GmbH & Co. OHG, Leverkusen. Das Elutionsmittel ist Dichlormethan. Säulenkombination aus vernetzten Styrol-Divinylbenzolharzen. Durchmesser der analytischen Säulen: 7,5 mm; Länge: 300 mm. Partikelgrößen des Säulenmaterials: 3 µm bis 20 µm. Konzentration der Lösungen: 0,2 Gew.-%. Flussrate: 1,0 ml/min, Temperatur der Lösungen: 30°C. Verwendung einer UV- und/oder RI-Detektion.

Ein Teil, bis zu 80 Mol-%, vorzugsweise von 20 Mol-% bis zu 50 Mol-%, der Carbonat-Gruppen in den erfindungsgemäß eingesetzten Polycarbonaten können durch aromatische Dicarbonsäureester-Gruppen ersetzt sein. Derartige Polycarbonate, die sowohl Säurereste der Kohlensäure als auch Säurereste von aromatischen Dicarbonsäuren in die Molekülkette eingebaut enthalten, werden als aromatische Polyestercarbonate bezeichnet. Sie werden im Rahmen der vorliegenden Erfindung unter dem Oberbegriff der thermoplastischen, aromatischen Polycarbonate subsumiert.

Die Herstellung der Polycarbonate erfolgt in bekannter Weise aus Dihydroxyarylverbindungen, Kohlensäurederivaten, gegebenenfalls Kettenabbrechern und gegebenenfalls Verzweigern, wobei zur Herstellung der Polyestercarbonate ein Teil der Kohlensäurederivate durch aromatische Dicarbonsäuren oder Derivate der Dicarbonsäuren ersetzt wird, und zwar je nach Maßgabe der in den aromatischen Polycarbonaten zu ersetzenden Carbonatstruktureinheiten durch aromatische Dicarbonsäureesterstruktureinheiten.

Für die Herstellung von Polycarbonaten geeignete Dihydroxyarylverbindungen sind solche der Formel (1)

HO-Z-OH (1),

in welcher
- Z: ein aromatischer Rest mit 6 bis 30 C-Atomen ist, der einen oder mehrere aromatische Kerne enthalten kann, substituiert sein kann und aliphatische oder cycloaliphatische Reste bzw. Alkylaryle oder Heteroatome als Brückenglieder enthalten kann.

Bevorzugt steht Z in Formel (1) für einen Rest der Formel (2) 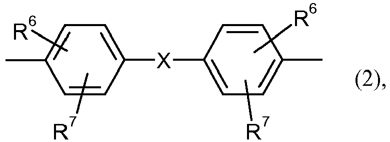 in der
- R⁶ und R⁷: unabhängig voneinander für H, C₁- bis C₁₈-Alkyl-, C₁- bis C₁₈-Alkoxy, Halogen wie Cl oder Br oder für jeweils gegebenenfalls substituiertes Aryl- oder Aralkyl, bevorzugt für H oder C₁- bis C₁₂-Alkyl, besonders bevorzugt für H oder C₁- bis C₈-Alkyl und ganz besonders bevorzugt für H oder Methyl stehen, und
- X: für eine Einfachbindung, -SO₂-, -CO-, -O-, -S-, C₁- bis C₆-Alkylen, C₂- bis C₅-Alkyliden oder C₅- bis C₆-Cycloalkyliden, welches mit C₁- bis C₆-Alkyl, vorzugsweise Methyl oder Ethyl, substituiert sein kann, ferner für C₆- bis C₁₂-Arylen, welches gegebenenfalls mit weiteren Heteroatome enthaltenden aromatischen Ringen kondensiert sein kann, steht.

Bevorzugt steht X für eine Einfachbindung, C₁- bis C₅-Alkylen, C₂- bis C₅-Alkyliden, C₅- bis C₆-Cycloalkyliden, -O-, -SO-, -CO-, -S-, -SO₂-
oder für einen Rest der Formel (3)

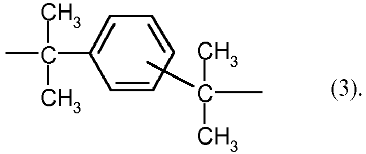

Beispiele für Dihydroxyarylverbindungen (Diphenole) sind: Dihydroxybenzole, Dihydroxydiphenyle, Bis-(hydroxyphenyl)-alkane, Bis-(hydroxyphenyl)-cycloalkane, Bis-(hydroxyphenyl)-aryle, Bis-(hydroxyphenyl)-ether, Bis-(hydroxyphenyl)-ketone, Bis-(hydroxyphenyl)-sulfide, Bis-(hydroxyphenyl)-sulfone, Bis-(hydroxyphenyl)-sulfoxide, 1,1'-Bis-(hydroxyphenyl)-diisopropylbenzole sowie deren kernalkylierte und kernhalogenierte Verbindungen.

Für die Herstellung der erfindungsgemäß zu verwendenden Polycarbonate und Copolycarbonate geeignete Dihydroxyarylverbindungen sind beispielsweise Hydrochinon, Resorcin, Dihydroxydiphenyl, Bis-(hydroxyphenyl)-alkane, Bis(hydroxyphenyl)-cycloalkane, Bis-(hydroxyphenyl)-sulfide, Bis-(hydroxyphenyl)-ether, Bis-(hydroxyphenyl)-ketone, Bis-(hydroxyphenyl)-sulfone, Bis-(hydroxyphenyl)-sulfoxide, α,α'-Bis-(hydroxyphenyl)-diisopropylbenzole sowie deren alkylierte, kernalkylierte und kernhalogenierte Verbindungen. Zur Herstellung von Copolycarbonaten können auch Si-haltige Telechele eingesetzt werden, sodass sogenannte Si-Copolycarbonate erhalten werden.

Bevorzugte Dihydroxyarylverbindungen sind 4,4'-Dihydroxydiphenyl, 2,2-Bis-(4-hydroxyphenyl)-1-phenylpropan, 1,1-Bis-(4-hydroxyphenyl)-phenylethan, 2,2-Bis-(4-hydroxyphenyl)propan, 2,4-Bis-(4-hydroxyphenyl)-2-methylbutan, 1,3-Bis-[2-(4-hydroxyphenyl)-2-propyl]benzol (Bisphenol M), 2,2-Bis-(3-methyl-4-hydroxyphenyl)-propan, Bis-(3,5-dimethyl-4-hydroxyphenyl)-methan, 2,2-Bis-(3,5-dimethyl-4-hydroxyphenyl)-propn, Bis-(3,5-dimethyl-4-hydroxyphenyl)-sulfon, 2,4-Bis-(3,5-dimethyl-4-hydroxyphenyl)-2-methylbutan, 1,3-Bis-[2-(3,5-dimethyl-4-hydroxyphenyl)-2-propyl]-benzol und 1,1-Bis-(4-hydroxyphenyl)-3,3,5-triamethylcyclohexan (Bisphenol TMC) sowie die Bisphenole der Formeln (I) bis (III) 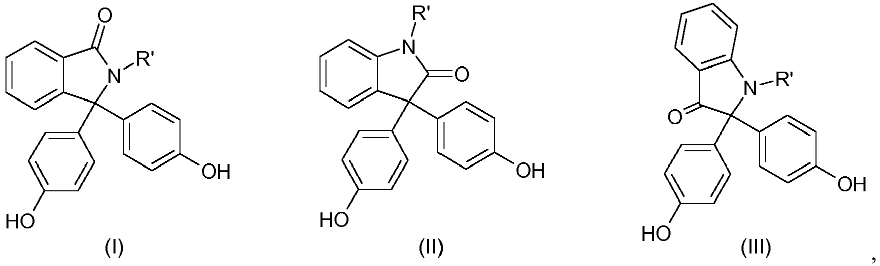 in denen R' jeweils für einen C₁- bis C₄-Alkylrest, Aralkylrest oder Arylrest, bevorzugt für einen Methylrest oder Phenylrest, ganz besonders bevorzugt für einen Methylrest, steht.

Besonders bevorzugte Dihydroxyarylverbindungen sind 4,4'-Dihydroxydiphenyl, 1,1-Bis-(4-hydroxyphenyl)-phenyl-ethan, 2,2-Bis-(4-hydroxyphenyl)-propan, 2,2-Bis(3,5-dimethyl-4-hydroxyphenyl)-propan, 1,1-Bis-(4-hydroxyphenyl)-cyclohexan und 1,1-Bis-(4-hydroxyphenyl)-3,3,5-trimethylcyclohexan (Bisphenol TMC) sowie die Dihydroxyarylverbindungen der Formeln (I), (II) und/oder (III).

Diese und weitere geeignete Dihydroxyarylverbindungen sind z.B. in US 2 999 835 A, 3 148 172 A, 2 991 273 A, 3 271 367 A, 4 982 014 A und 2 999 846 A, in den deutschen Offenlegungsschriften 1 570 703 A, 2 063 050 A, 2 036 052 A, 2 211 956 A und 3 832 396 A, der französischen Patentschrift 1 561 518 A1, in der Monographie "H. Schnell, Chemistry and Physics of Polycarbonates, Interscience Publishers, New York 1964, S. 28 ff.; S.102 ff.", und in "D.G. Legrand, J.T. Bendler, Handbook of Polycarbonate Science and Technology, Marcel Dekker New York 2000, S. 72ff." beschrieben.

Im Falle der Homopolycarbonate wird nur eine Dihydroxyarylverbindung eingesetzt, im Falle von Copolycarbonaten werden zwei oder mehr Dihydroxyarylverbindungen eingesetzt.

Besonders bevorzugte Polycarbonate sind das Homopolycarbonat auf Basis von Bisphenol A, das Homopolycarbonat auf Basis von 1,1-Bis-(4-hydroxyphenyl)-3,3,5-trimethylcyclohexan und die Copolycarbonate auf Basis der beiden Monomere Bisphenol A und 1,1-Bis-(4-hydroxyphenyl)-3,3,5-trimethylcyclohexan beziehungsweise der beiden Monomere Bisphenol A und 4,4'-Dihydroxydiphenyl, sowie von den Dihydroxyarylverbindungen der Formeln (I), (II) und/oder (III) 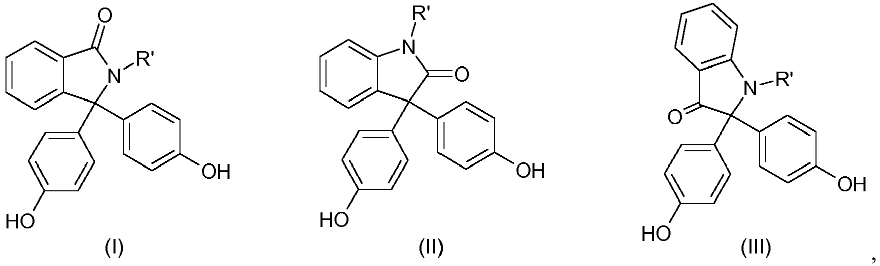 in denen R' jeweils für C₁- bis C₄-Alkyl, Aralkyl oder Aryl, bevorzugt für Methyl oder Phenyl, ganz besonders bevorzugt für Methyl, steht,
abgeleitete Homo- oder Copolycarbonate, insbesondere mit Bisphenol A.

Die verwendeten Dihydroxyarylverbindungen, wie auch alle anderen der Synthese zugesetzten Chemikalien und Hilfsstoffe, können mit den aus ihrer eigenen Synthese, Handhabung und Lagerung stammenden Verunreinigungen kontaminiert sein. Es ist jedoch wünschenswert, mit möglichst reinen Rohstoffen zu arbeiten.

Bevorzugt sind auch Copolycarbonate mit einer oder mehreren Monomereinheiten eines Siloxans der allgemeinen Formel (IV) 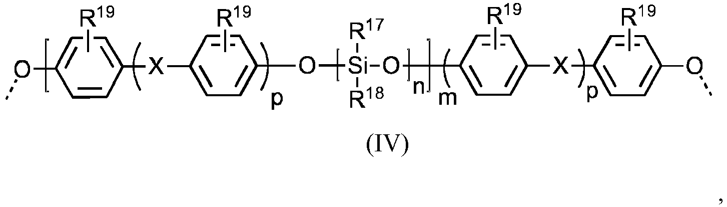 in der
R¹⁹ für Wasserstoff, Cl, Br oder einen C₁- bis C₄-Alkylrest, vorzugsweise für Wasserstoff oder einen Methylrest, besonders bevorzugt für Wasserstoff, steht,
R¹⁷ und R¹⁸ gleich oder verschieden sind und unabhängig voneinander für einen Arylrest, einen C₁-bis C₁₀-Alkylrest oder einen C₁- bis C₁₀-Alkylarylrest, bevorzugt jeweils für einen Methylrest, stehen und wobei
X eine Einfachbindung, -CO-, -O-, ein C₁- bis C₆-Alkylenrest, ein C₂- bis Cs-Alkylidenrest, ein C₅-bis C₁₂-Cycloalkylidenrest oder ein C₆- bis C₁₂-Arylenrest ist, der optional mit weiteren aromatischen Ringen kondensiert sein kann, welche Heteroatome enthalten, wobei X bevorzugt eine Einfachbindung, ein C₁- bis Cs-Alkylenrest, ein C₂- bis C₅-Alkylidenrest, ein C₅- bis C₁₂-Cycloalkylidenrest, -O- oder -CO- ist, weiter bevorzugt eine Einfachbindung, ein Isopropylidenrest, ein C₅- bis C₁₂-Cycloalkylidenrest oder -O- ist, ganz besonders bevorzugt ein Isopropylidenrest, ist,
n eine Zahl von 1 bis 500, vorzugsweise von 10 bis 400, besonders bevorzugt von 10 bis 100, ganz besonders bevorzugt von 20 bis 60, ist,
m eine Zahl von 1 bis 10, bevorzugt von 1 bis 6, besonders bevorzugt von 2 bis 5, ist,
p 0 oder 1, bevorzugt 1, ist,
und der Wert von n mal m vorzugsweise zwischen 12 und 400, weiter bevorzugt zwischen 15 und 200 liegt,
wobei das Siloxan bevorzugt mit einem Polycarbonat in Gegenwart eines organischen oder anorganischen Salzes einer schwachen Säure mit einem pK_{A} Wert von 3 bis 7 (25°C) umgesetzt wird.

Copolycarbonate mit Monomereinheiten der Formel (IV) und insbesondere auch deren Herstellung sind in der WO 2015/052106 A2 beschrieben.

Der Gesamtanteil der Monomereinheiten beruhend auf den Formeln (I), (II), (III), 4,4'-Dihydroxydiphenyl und/oder Bisphenol TMC im Copolycarbonat beträgt vorzugsweise 0,1 - 88 mol-%, besonders bevorzugt 1 - 86 mol-%, ganz besonders bevorzugt 5 - 84 mol-% und insbesondere 10 - 82 mol-% (bezogen auf die Summe der Mole eingesetzter Dihydroxyarylverbindungen).

Die Copolycarbonate können als block- und statistisches Copolycarbonat vorliegen. Besonders bevorzugt sind statistische Copolycarbonate.

Dabei ergibt sich das Verhältnis der Häufigkeit der Diphenolat-Monomereinheiten im Copolycarbonat aus dem Molverhältnis der eingesetzten Dihydroxyarylverbindungen.

Die relative Lösungsviskosität der Copolycarbonate, bestimmt nach ISO 1628-4:1999, liegt bevorzugt im Bereich von = 1,15 - 1,35.

Die zur Regelung des Molekulargewichtes benötigten monofunktionellen Kettenabbrecher, wie Phenole oder Alkylphenole, insbesondere Phenol, p-tert.-Butylphenol, iso-Octylphenol, Cumylphenol, deren Chlorkohlensäureester oder Säurechloride von Monocarbonsäuren bzw. Gemische aus diesen Kettenabbrechern, werden entweder mit dem Bisphenolat bzw. den Bisphenolaten der Reaktion zugeführt oder aber zu jedem beliebigen Zeitpunkt der Synthese zugesetzt, solange im Reaktionsgemisch noch Phosgen oder Chlorkohlensäureendgruppen vorhanden sind, bzw. im Falle der Säurechloride und Chlorkohlensäureester als Kettenabbrecher, solange genügend phenolische Endgruppen des sich bildenden Polymers zur Verfügung stehen. Vorzugsweise werden der oder die Kettenabbrecher jedoch nach der Phosgenierung an einem Ort oder zu einem Zeitpunkt zugegeben, wenn kein Phosgen mehr vorliegt, aber der Katalysator noch nicht dosiert wurde, bzw. sie werden vor dem Katalysator, mit dem Katalysator zusammen oder parallel zudosiert.

In der gleichen Weise werden eventuell zu verwendende Verzweiger oder Verzweigermischungen der Synthese zugesetzt, üblicherweise jedoch vor den Kettenabbrechern. Üblicherweise werden Trisphenole, Quarterphenole oder Säurechloride von Tri- oder Tetracarbonsäuren verwendet oder auch Gemische der Polyphenole oder der Säurechloride.

Einige der als Verzweiger verwendbaren Verbindungen mit drei oder mehr als drei phenolischen Hydroxylgruppen sind beispielsweise Phloroglucin, 4,6-Dimethyl-2,4,6-tri-(4-hydroxyphenyl)-hepten-2, 4,6-Dimethyl-2,4,6-tri-(4-hydroxyphenyl)-heptan, 1,3,5-Tris-(4-hydroxyphenyl)-benzol, 1,1,1-Tri-(4-hydroxyphenyl)-ethan, Tris-(4-hydroxyphenyl)-phenylmethan, 2,2-Bis-[4,4-bis-(4-hydroxyphenyl)-cyclohexyl] -propan, 2,4-Bis-(4-hydroxyphenyl-isopropyl)-phenol, Tetra-(4-hydroxyphenyl)-methan.

Einige der sonstigen trifunktionellen Verbindungen sind 2,4-Dihydroxybenzoesäure, Trimesinsäure, Cyanurchlorid und 3,3-Bis-(3-methyl-4-hydroxyphenyl)-2-oxo-2,3-dihydroindol.

Bevorzugte Verzweiger sind 3,3-Bis-(3-methyl-4-hydroxyphenyl)-2-oxo-2,3-dihydroindol und 1,1,1-Tri-(4-hydroxyphenyl)-ethan.

Die Menge der gegebenenfalls einzusetzenden Verzweiger beträgt 0,05 Mol-% bis 2 Mol-%, bezogen wiederum auf Mole an jeweils eingesetzten Diphenolen.

Die Verzweiger können entweder mit den Diphenolen und den Kettenabbrechern in der wässrigen alkalischen Phase vorgelegt werden oder in einem organischen Lösungsmittel gelöst vor der Phosgenierung zugegeben werden.

Alle diese Maßnahmen zur Herstellung der Polycarbonate sind dem Fachmann geläufig.

Für die Herstellung der Polyestercarbonate geeignete aromatische Dicarbonsäuren sind beispielsweise Orthophthalsäure, Terephthalsäure, Isophthalsäure, tert-Butylisophthalsäure, 3,3'-Diphenyldicarbonsäure, 4,4'-Diphenyldicarbonsäure, 4,4-Benzophenondicarbonsäure, 3,4'-Benzophenondicarbonsäure, 4,4'-Diphenyletherdicarbonsäure, 4,4'-Diphenylsulfondicarbonsäure, 2,2-Bis-(4-carboxyphenyl)-propan, Trimethyl-3-phenylindan-4,5'-dicarbonsäure.

Von den aromatischen Dicarbonsäuren werden besonders bevorzugt die Terephthalsäure und/oder Isophthalsäure eingesetzt.

Derivate der Dicarbonsäuren sind die Dicarbonsäuredihalogenide und die Dicarbonsäuredialkylester, insbesondere die Dicarbonsäuredichloride und die Dicarbonsäuredimethylester.

Der Ersatz der Carbonatgruppen durch die aromatischen Dicarbonsäureestergruppen erfolgt im Wesentlichen stöchiometrisch und auch quantitativ, so dass das molare Verhältnis der Reaktionspartner sich auch im fertigen Polyestercarbonat wiederfindet. Der Einbau der aromatischen Dicarbonsäureestergruppen kann sowohl statistisch als auch blockweise erfolgen.

Bevorzugte Herstellungsweisen der erfindungsgemäß zu verwendenden Polycarbonate, einschließlich der Polyestercarbonate, sind das bekannte Grenzflächenverfahren und das bekannte Schmelzeumesterungsverfahren (vgl. z. B. WO 2004/063249 A1, WO 2001/05866 A1, US 5,340,905 A, US 5,097,002 A, US-A 5,717,057 A).

Im ersten Fall dienen als Säurederivate vorzugsweise Phosgen und gegebenenfalls Dicarbonsäuredichloride, im letzteren Fall vorzugsweise Diphenylcarbonat und gegebenenfalls Dicarbonsäurediester. Katalysatoren, Lösungsmittel, Aufarbeitung, Reaktionsbedingungen etc. für die Polycarbonatherstellung bzw. Polyestercarbonatherstellung sind in beiden Fällen hinreichend beschrieben und bekannt.

Zusammensetzungen i.S. der Erfindung sind bevorzugt "Polycarbonat-Zusammensetzungen" oder auch auf "Polycarbonat basierende Zusammensetzungen". Dieses sind solche Zusammensetzungen, deren Basismaterial, d.h. überwiegend vorhandene Komponente, ein Polycarbonat ist. "Überwiegend" bedeutet hierbei mindestens 55 Gew.-%, bevorzugt mindestens 60 Gew.-%, weiter bevorzugt mindestens 68 Gew.-%, noch weiter bevorzugt mindestens 70 Gew.-%, besonders bevorzugt mindestens 74 Gew.-%, aromatisches Polycarbonat, bezogen auf die Gesamtzusammensetzung.

### Komponente B

Erfindungsgemäß enthalten die Zusammensetzungen als Komponente B mindestens ein Oxid eines Metalls oder Halbmetalls der 3. oder 4. Hauptgruppe oder 4. Nebengruppe. Die Oxide eines Metalls oder Halbmetalls der 3. oder 4. Hauptgruppe oder 4. Nebengruppe können alleine oder in Mischung eingesetzt werden. Bevorzugt werden Titandioxid, Siliciumdioxid und/oder auf Siliciumdioxid-basierende Komponenten, wie Glasfasern, und/oder Aluminiumoxid, besonders bevorzugt Titandioxid und/oder Siliciumdioxid, ganz besonders bevorzugt Titandioxid, insbesondere ohne weitere Oxide eines Metalls oder Halbmetalls der 3. oder 4. Hauptgruppe oder 4. Nebengruppe, von Beschichtungen des Titandioxids und/oder Siliciumdioxids abgesehen, eingesetzt.

Komponente B ist in den erfindungsgemäßen Zusammensetzungen in einer Menge von bevorzugt 5 bis 44 Gew.-%, weiter bevorzugt von 5 bis 40 Gew.-%, noch weiter bevorzugt von 8 bis 32 Gew.-%, besonders bevorzugt von 10 bis 30 Gew.-%, ganz besonders bevorzugt in einer Menge von 15 bis 25 Gew.-%, jeweils bezogen auf die Gesamtzusammensetzung, enthalten.

Das Siliciumdioxid ist bevorzugt natürlich vorkommendes oder synthetisch hergestelltes Quarz sowie Quarzglas.

Die in erfindungsgemäßen Zusammensetzungen verwendeten Quarze weisen bevorzugt eine sphärische und/oder annähernd sphärische Korngestalt auf. Annähernd sphärisch bedeutet hierbei Folgendes: Sofern die Kugel durch von einem gemeinsamen Ursprung ausgehende, in den Raum gerichtete Achsen gleicher Länge beschrieben wird, wobei die Achsen den Radius der Kugel in alle Raumrichtungen definieren, ist für die sphärischen Partikel eine Abweichung der Achsenlängen vom Idealzustand der Kugel von bis zu 20% möglich, um noch als annähernd sphärisch zu gelten.

Die Quarze sind bevorzugt durch einen mittleren Durchmesser d₅₀, bestimmt nach ISO 13320:2009, von 2 bis 10 µm, weiter bevorzugt von 2,5 bis 8,0 µm, noch weiter bevorzugt von 3 bis 5 µm gekennzeichnet, wobei ein oberer Durchmesser d₉₅, bestimmt nach ISO 13320:2009, von entsprechend 6 bis 34 µm, weiter bevorzugt von 6,5 bis 25,0 µm, noch weiter bevorzugt von 7 bis 15 µm, und besonders bevorzugt von 10 µm bevorzugt ist.

Bevorzugt weisen die Quarze eine spezifische BET-Oberfläche, bestimmt durch Stickstoffadsorption gemäß ISO 9277:2010, von 0,4 bis 8,0 m²/g, weiter bevorzugt von 2 bis 6 m²/g, und besonders bevorzugt von 4,4 bis 5,0 m²/g auf.

Weiter bevorzugte Quarze weisen nur maximal 3 Gew.-% Nebenbestandteile auf, wobei vorzugsweise der Gehalt an
Al₂O₃ < 2,0 Gew.-%,
Fe₂O₃< 0,05 Gew.-%,
(CaO + MgO) < 0,1 Gew.-%,
(Na₂O + K₂O) < 0,1 Gew.-% ist, jeweils bezogen auf das Gesamtgewicht des Quarzes bzw. Silikats.

Bevorzugt werden Quarze mit einem pH-Wert, gemessen gemäß ISO 10390:2005 in wässriger Suspension, im Bereich 6 bis 9, weiter bevorzugt 6,5 bis 8,0 eingesetzt.

Sie weisen bevorzugt eine Ölabsorptionszahl gemäß DIN EN ISO 787-5:1995-10 von bevorzugt 20 bis 30 g/100 g auf.

In bevorzugter Ausführungsform handelt es sich bei Komponente B um feinteilige Quarzmehle, die durch eisenfreie Mahlung mit nachfolgender Windsichtung aus aufbereitetem Quarzsand hergestellt wurden.

Besonders bevorzugt wird "fused Silica" als Komponente B eingesetzt, wobei es sich um Quarzglas handelt, aufgeschmolzenes und wieder erstarrtes Siliciumdioxid.

Es können Quarze bzw. Quarzglase zum Einsatz kommen, die eine Schlichte an der Oberfläche aufweisen, wobei bevorzugt Epoxy-modifizierte, Polyurethan-modifizierte und nichtmodifizierte Silanverbindungen, Methylsiloxan-, und Methacrylsilan-Schlichten oder Mischungen der vorgenannten Silanverbindungen zum Einsatz kommen. Besonders bevorzugt ist eine Epoxysilanschlichte. Die Beschlichtung von Siliciumdioxid erfolgt nach den allgemeinen, dem Fachmann bekannten Verfahren.

Bevorzugt weist das für erfindungsgemäße Zusammensetzungen eingesetzte Siliciumdioxid jedoch keine Schlichte auf.

Geeignete Titandioxide sind bevorzugt solche, welche nach dem Chlorid-Verfahren hergestellt, hydrophobiert, speziell nachbehandelt und für den Einsatz in Polycarbonat geeignet sind, z. B. das Handelsprodukt Kronos 2230 (Kronos Titan).

Zu möglichen Oberflächenmodifikationen von Titandioxid zählen anorganische und organische Modifikationen. Hierzu zählen z.B. Oberflächenmodifikationen auf Aluminium- oder Polysiloxanbasis. Eine anorganische Beschichtung kann 0 bis 5 Gew.-% Siliciumdioxid und/oder Aluminiumoxid enthalten. Eine Modifikation auf organischer Basis kann 0 bis 3 Gew.-% eines hydrophoben Benetzungsmittels enthalten.

Das Titandioxid hat bevorzugt eine Ölabsorptionszahl, bestimmt nach DIN EN ISO 787-5:1995-10, von 12 bis 18 g/100 g Titandioxid, weiter bevorzugt von 13 bis 17 g/ 100 g Titandioxid, besonders bevorzugt von 13,5 bis 15,5 g/100 g Titandioxid.

Besonders bevorzugt ist Titandioxid mit der Normbezeichnung R2 gemäß DIN EN ISO 591, Teil 1, welches mit Aluminium- und/oder Siliciumverbindungen stabilisiert ist und einen Titandioxid-Gehalt von mindestens 96,0 Gew.-% aufweist. Derartige Titandioxide sind unter den Markennamen Kronos® 2233 und Kronos® 2230 erhältlich.

Sofern Aluminiumoxid als Komponente B eingesetzt wird, hat dieses bevorzugt einen pH-Wert von 7,0 bis 7,4, gemessen gemäß ISO 10390:2005 in wässriger Suspension. Es ist bevorzugt unbeschlichtet.

Die Mengenangabe für Komponente B bezieht sich jeweils auf das Gesamtgewicht des eingesetztes Oxids, ggf. inklusive Beschlichtung bzw. Oberflächenmodifizierung.

### Komponente C

Komponente C sind PMMI-Copolymere. Dieses sind thermoplastische Kunststoffe, welche teilweise imidierte Methacrylpolymerisate sind. PMMI-Copolymere werden insbesondere erhalten durch Umsetzung von PMMA mit Methylamin in Dispersion oder in der Schmelze in einem Reaktor. Ein geeignetes Verfahren ist beispielsweise in DE 1 077 872 A1 beschrieben. Dabei werden entlang der Polymerkette Imidstrukturen erzeugt, wobei, je nach Umsetzungsgrad, auch noch Methacrylsäureanhydrid- und freie Methacrylsäure-Funktionalitäten gebildet werden. Der Anteil an Imidfunktionalitäten im Copolymer bestimmt dessen Wärmeformbeständigkeit. Der Umsetzungsgrad ist gezielt einstellbar.

PMMI-Copolymere weisen Methylmethacrylat- (MMA, 4a), Methylmethacrylimid- (MMI, 6), Methylmethacrylsäure- (MMS, 4b) und Methylmethacrylanhydrid-Einheiten (MMAH, 5) auf. Bevorzugt sind mindestens 90, weiter bevorzugt mindestens 95 Gew.-% des PMMI-Copolymers, bezogen auf das Gesamtgewicht des PMMI-Copolymers, MMA-, MMI-, MMS- und MMAH-Einheiten. Besonders bevorzugt bestehen die PMMI-Copolymere aus diesen Bausteinen.

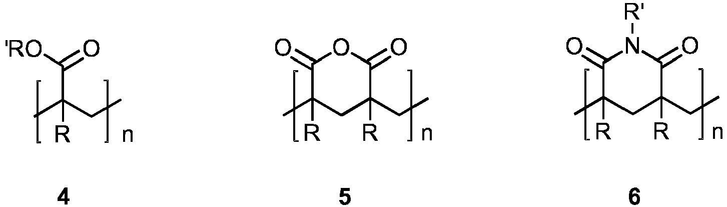

MMA: 4a (R=R'=CH₃), MMS: 4b (R=CH₃, R'=H), MMAH: 5 (R=CH₃), MMI: 6 ((R=R'=CH₃).

Die Bausteine und deren Anteile am PMMI-Copolymer können insbesondere mittels quantitativer ¹H-NMR-Spektroskopie, anhand eindeutiger chemischer Verschiebung der R'-Signale, ermittelt werden. Die Aufschlüsselung der Signale der Säure- und Anhydrid-Monomerbausteine ist nicht eindeutig möglich, weshalb eine zusammengefasste Betrachtung dieser Bausteine zu empfehlen ist.

Das PMMI-Copolymer hat bevorzugt einen MMI-Anteil von mindestens 30 Gew.-%, bevorzugt von mindestens 35 Gew.-%, weiter bevorzugt von 35 bis 96 Gew.-%, besonders bevorzugt von 36 bis 95 Gew.-% MMI, bezogen auf das Gesamtgewicht des PMMI-Copolymers.

Der MMA-Anteil des Copolymers beträgt bevorzugt 3 bis 65 Gew.-%, bevorzugt 4 bis 60 Gew.-%, besonders bevorzugt 4,0 bis 55 Gew.-%, bezogen auf das Gesamtgewicht des PMMI-Copolymers.

Der Anteil an MMS und MMAH beträgt in Summe bevorzugt bis zu 15 Gew.-%, weiter bevorzugt bis zu 12 Gew.-%, besonders bevorzugt 0,5 bis 12 Gew.-%, bezogen auf das Gesamtgewicht des PMMI-Copolymers.

Die Säurezahl der PMMI-Copolymere, bestimmt nach DIN 53240-1:2013-06, beträgt bevorzugt 15 bis 50 mg KOH/g, weiter bevorzugt 20 bis 45 mg KOH/g, noch weiter bevorzugt 22 bis 42 mg KOH/g.

Ein ganz besonders bevorzugtes PMMI-Copolymer hat einen MMI-Anteil von 36,8 Gew.-%, einen MMA-Anteil von 51,7 Gew.-% und einen MMS+MMAH-Anteil von 11,5 Gew.-%, jeweils bezogen auf das Gesamtgewicht des PMMI-Copolymers, bestimmt mittels ¹H-NMR-Spektroskopie, und eine Säurezahl von 22,5 mg KOH/g, bestimmt nach DIN 53240-1:2013-06.

Ein alternativ ganz besonders bevorzugtes PMMI-Copolymer hat einen MMI-Anteil von 83,1 Gew.-%, einen MMA-Anteil von 13,6 Gew.-% und einen MMS+MMAH-Anteil von 3,3 Gew.-%, jeweils bezogen auf das Gesamtgewicht des PMMI-Copolymers, bestimmt mittels ¹H-NMR-Spektroskopie, und eine Säurezahl von 22,5 mg KOH/g, bestimmt nach DIN 53240-1:2013-06.

Ein ebenfalls alternativ ganz besonders bevorzugtes PMMI-Copolymer hat einen MMI-Anteil von 94,8 Gew.-%, einen MMA-Anteil von 4,6 Gew.-% und einen MMS+MMAH-Anteil von 0,6 Gew.-%, jeweils bezogen auf das Gesamtgewicht des PMMI-Copolymers, bestimmt mittels ¹H-NMR-Spektroskopie, und eine Säurezahl von 41,5 mg KOH/g, bestimmt nach DIN 53240-1:2013-06.

Geeignetes PMMI ist beispielsweise bei der Firma Evonik Industries AG unter der Marke "PLEXIMID®" erhältlich.

In den Polycarbonat-Zusammensetzungen, enthaltend Oxide von Metallen oder Halbmetallen der 3. oder 4. Hauptgruppe oder 4. Nebengruppe, beträgt die Zugabemenge für das PMMI-Copolymer bevorzugt mindestens 1 Gew.-%, weiter bevorzugt mindestens 1,5 Gew.-%, noch weiter bevorzugt mindestens 2 Gew.-%, noch weiter bevorzugt mindestens 3 Gew.-%, besonders bevorzugt 4 Gew.-%, ganz besonders bevorzugt bis 6 Gew.-%, jeweils bezogen auf das Gesamtgewicht der Polycarbonat-Zusammensetzung.

Bevorzugt beträgt das Verhältnis von Komponente B zum PMMI-Copolymer ≤ 40, weiter bevorzugt ≤ 30, noch weiter bevorzugt ≤ 25, insbesondere ≤ 20.

Die Glasübergangstemperatur des PMMI-Copolymers, bestimmt gemäß DIN EN ISO 11357-2:2014-07 bei einer Aufheizrate von 20°C/min, beträgt bevorzugt 130 bis 170°C. Damit ist das PMMI-Copolymer unter den für Polycarbonat - einschließlich den für hochtemperaturstabilen Polycarbonat-Copolymeren- üblichen Verarbeitungsbedingungen stabil.

### Komponente D

Die erfindungsgemäßen Zusammensetzungen können ein oder mehrere von Komponente B und Komponente C verschiedene, weitere Additive enthalten, welche vorliegend unter "Komponente D" zusammengefasst sind.

Die Additive sind optional (0 Gew.-%) bevorzugt bis zu 20,0 Gew.-%, weiter bevorzugt bis zu 10,0 Gew.-%, noch weiter bevorzugt zu 0,10 bis 8,0 Gew.-%, besonders bevorzugt zu 0,2 bis 3,0 Gew.-% in der erfindungsgemäßen Zusammensetzung enthalten, wobei sich diese Gewichtsprozente auf das Gesamtgewicht der Zusammensetzung beziehen.

Solche Additive, wie sie üblicherweise Polycarbonaten zugesetzt werden, sind beispielsweise in EP 0 839 623 A1, WO 96/15102 A2, EP 0 500 496 A1 oder im "Plastics Additives Handbook", Hans Zweifel, 5th Edition 2000, Hanser Verlag, München beschrieben. Geeignete Additive sind insbesondere Flammschutzmittel, Antitropfmittel, Schlagzähmodifikatoren, Füllstoffe, Antistatika, organische und anorganische Farbmittel einschließlich Pigmenten und Ruß, Gleit- und/oder Entformungsmittel, Thermostabilisatoren, Blendpartner wie ABS, Polyester, z. B. PET und/oder PBT, oder SAN, Verträglichkeitsvermittler, UV-Absorber und/oder IR-Absorber.

Bevorzugte Entformungsmittel sind Ester aliphatischer langkettiger Carbonsäuren mit ein- oder mehrwertigen aliphatischen und/oder aromatischen Hydroxyverbindungen. Besonders bevorzugt sind Pentaerythrittetrastearat, Glycerinmonostearat, Stearylstearat und Propandioldistearat, bzw. Gemische daraus.

Bevorzugte UV-Stabilisatoren weisen eine möglichst geringe Transmission unterhalb 400 nm und eine möglichst hohe Transmission oberhalb von 400 nm auf. Für den Einsatz in der erfindungsgemäßen Zusammensetzung besonders geeignete Ultraviolett-Absorber sind Benzotriazole, Triazine, Benzophenone und/oder arylierte Cyanoacrylate.

Besonders geeignete Ultraviolett-Absorber sind Hydroxy-Benzotriazole, wie 2-(3',5'-Bis-(1,1-dimethylbenzyl)-2'-hydroxy-phenyl)-benzotriazol (Tinuvin® 234, Ciba Spezialitätenchemie, Basel), 2-(2'-Hydroxy-5'-(tert.-octyl)-phenyl)-benzotriazol (Tinuvin® 329, Ciba Spezialitätenchemie, Basel), 2-(2'-Hydroxy-3'-(2-butyl)-5'-(tert.butyl)-phenyl)-benzotriazol (Tinuvin® 350, Ciba Spezialitätenchemie, Basel), Bis-(3-(2H-benztriazolyl)-2-hydroxy-5-tert.-octyl)methan, (Tinuvin® 360, Ciba Spezialitätenchemie, Basel), (2-(4,6-Diphenyl-1,3,5-triazin-2-yl)-5-(hexyloxy)-phenol (Tinuvin® 1577, Ciba Spezialitätenchemie, Basel), sowie der Benzophenone 2,4-Dihydroxy-benzophenon (Chimasorb® 22, Ciba Spezialitätenchemie, Basel) und 2-Hydroxy-4-(octyloxy)-benzophenon (Chimassorb® 81, Ciba, Basel), 2-Cyano-3,3-diphenyl-2-propensäure-2-ethylhexylester, 2,2-Bis[[(2-cyano-1-oxo-3,3-diphenyl-2-propenyl)oxy]-methyl]-1,3-propandiylester (9CI) (Uvinul® 3030, BASF AG Ludwigshafen), 2-[2-Hydroxy-4-(2-ethylhexyl)oxy]phenyl-4,6-di(4-phenyl)phenyl-1,3,5-triazin (CGX UVA 006, Ciba Spezialitätenchemie, Basel) oder Tetraethyl-2,2'-(1,4-phenylen-dimethyliden)-bismalonat (Hostavin® B-Cap, Clariant AG).

Besonders bevorzugte spezielle UV-Stabilisatoren sind beispielsweise Tinuvin® 360, Tinuvin® 350, Tinuvin® 329, Hostavin® B-CAP, besonders bevorzugt TIN 329 und Hostavin® B-Cap. Es können auch Mischungen dieser Ultraviolett-Absorber eingesetzt werden.

Sofern UV-Absorber enthalten sind, enthält die Zusammensetzung bevorzugt Ultraviolett-Absorber in einer Menge von 0 ppm bis 6000 ppm, weiter bevorzugt 500 ppm bis 5000 ppm, noch weiter bevorzugt 1000 ppm bis 2000 ppm, bezogen auf die Gesamtzusammensetzung.

Geeignete IR-Absorber sind beispielsweise in EP 1 559 743 A1, EP 1 865 027 A1, DE 10022037 A1, DE 10006208 A1 sowie in den italienischen Patentanmeldungen RM2010A000225, RM2010A000227 sowie RM2010A000228 offenbart. Von den in der zitierten Literatur genannten IR-Absorbern sind solche auf Borid- und Wolframatbasis, insbesondere Cäsiumwolframat oder Zink-dotiertes Cäsiumwolframat, sowie auf ITO und ATO basierende Absorber sowie Kombinationen daraus bevorzugt.

Geeignete Farbmittel können Pigmente, organische und anorganische Pigmente, Ruß und/oder Farbstoffe sein. Von Komponente B verschiedene Farbmittel oder Pigmente im Sinne der vorliegenden Erfindung sind Schwefel-haltige Pigmente wie Cadmiumrot oder Cadmiumgelb, Eisencyanid-basierte Pigmente wie Berliner Blau, Oxid-Pigmente wie Zinkoxid, rotes Eisenoxid, schwarzes Eisenoxid, Chromoxid, Titangelb, Zink-Eisen-basiertes Braun, Titan-Cobalt-basiertes Grün, Cobaltblau, Kupfer-Chrom-basiertes Schwarz und Kupfer-Eisen-basiertes Schwarz oder Chrombasierte Pigmente wie Chromgelb, Phthalocyanin-abgeleitete Farbstoffe wie Kupfer-Phthalocyanin-Blau oder Kupfer-Phthalocyanin-Grün, kondensierte polycyclische Farbstoffe und Pigmente wie Azo-basierende (z. B. Nickel-Azogelb), Schwefel-Indigo-Farbstoffe, Perinonbasierte, Perylen-basierte, Chinacridon-abgeleitete, Dioxazin-basierte, Isoindolinon-basierte und Chinophthalon-abgeleitete Derivate, Anthrachinon-basierte, heterocyclische Systeme. Farbmittel gemäß Komponente D ist jedoch insbesondere kein Titandioxid, da dieses als Komponente B erfasst ist.

Konkrete Beispiele für Handelsprodukte sind z. B. MACROLEX® Blau RR, MACROLEX® Violett 3R, MACROLEX® Violett B (Lanxess AG, Deutschland), Sumiplast® Violett RR, Sumiplast® Violett B, Sumiplast® Blau OR, (Sumitomo Chemical Co., Ltd.), Diaresin® Violett D, Diaresin® Blau G, Diaresin® Blau N (Mitsubishi Chemical Corporation), Heliogen® Blau oder Heliogen® Grün (BASF AG, Deutschland). Von diesen sind Cyaninderivate, Chinolinderivate, Anthrachinonderivate, Phthalocyaninderivate bevorzugt.

Füllstoffe verschieden von Komponente B können ebenfalls zugesetzt werden, sofern sie nach Art und Menge das Eigenschaftsniveau der vorliegenden Erfindung nicht beeinträchtigen. Diese können z.B. partikel-, schuppenförmigen oder faserförmigen Charakter haben. Beispielhaft seien an dieser Stelle Kreide, Bariumsulfat, Silikate/Aluminosilikate wie z.B. Wollastonit, Glimmer/Tonschichtmineralien, Montmorillonit, insbesondere auch in einer durch Ionenaustausch modifizierten, organophilen Form, Kaolin, Zeolithe, Vermiculit, Carbonfasern, Magnesiumhydroxid und Aluminiumhydroxid genannt. Es können auch Mischungen verschiedener anorganischer Materialien zum Einsatz kommen.

Darüber hinaus können weitere Bestandteile zugesetzt werden, die nach Art des Bestandteils und Menge das Eigenschaftsniveau der vorliegenden Erfindung nicht beeinträchtigen.

Erfindungsgemäß bevorzugte Zusammensetzungen enthalten
A) mindestens 55 Gew.-% aromatisches Polycarbonat,
B) 5 bis 44 Gew.-% ein oder mehrere Oxide von Metallen oder Halbmetallen der 3. Hauptgruppe, 4. Hauptgruppe und/oder 4. Nebengruppe,
C) 0,1 bis 8 Gew.-% PMMI-Copolymer und
D) optional weitere Additive.

Weiter bevorzugte erfindungsgemäße Zusammensetzungen enthalten
A) mindestens 56 Gew.-%, bevorzugt mindestens 60 Gew.-%, aromatisches Polycarbonat,
B) 10 bis 35 Gew.-% ein oder mehrere Oxide von Metallen oder Halbmetallen der 3. Hauptgruppe, 4. Hauptgruppe und/oder 4. Nebengruppe,
C) 0,2 bis 6 Gew.-% PMMI-Copolymer und
D) optional weitere Additive.

Noch weiter bevorzugte erfindungsgemäße Zusammensetzungen bestehen aus
A) mindestens 60 Gew.-% aromatischem Polycarbonat,
B) 10 bis 30 Gew.-% einem oder mehreren Oxiden von Metallen oder Halbmetallen der 3. Hauptgruppe, 4. Hauptgruppe und/oder 4. Nebengruppe,
C) 0,2 bis 6 Gew.-% PMMI-Copolymer und
D) optional ein oder mehreren von Komponente B und C verschiedenen, weiteren Additiven, ausgewählt aus der Gruppe, bestehend aus Flammschutzmitteln, Antitropfmitteln, Schlagzähmodifikatoren, Füllstoffen, Antistatika, Farbmitteln, Pigmenten, Ruß, Gleit- und/oder Entformungsmitteln, Thermostabilisatoren, Verträglichkeitsvermittlern, UV-Absorbern und/oder IR-Absorbern.

Besonders bevorzugt sind solche Zusammensetzungen, welche aus
A) mindestens 68 Gew.-% aromatischem Polycarbonat,
B) bis zu, d.h. einschließlich, 20 Gew.-% einem oder mehreren Oxiden von Metallen oder Halbmetallen der 3. Hauptgruppe, 4. Hauptgruppe und/oder 4. Nebengruppe,
C) 1 Gew.-% bis 3 Gew.-% PMMI-Copolymer und
D) optional ein oder mehreren von Komponente B und C verschiedenen, weiteren Additiven, ausgewählt aus der Gruppe, bestehend aus Flammschutzmitteln, Antitropfmitteln, Schlagzähmodifikatoren, Füllstoffen, Antistatika, Farbmitteln, Pigmenten, Ruß, Gleit- und/oder Entformungsmitteln, Thermostabilisatoren, Verträglichkeitsvermittlern, UV-Absorbern und/oder IR-Absorbern,
bestehen. Solche Zusammensetzungen weisen eine hervorragende mechanische Performance und eine gute Wärmeformbeständigkeit auf.

Ganz besonders bevorzugte erfindungsgemäße Zusammensetzungen bestehen aus
A) mindestens 68 Gew.-% aromatischem Polycarbonat,
B) 15 bis 25 Gew.-% einem oder mehreren Oxiden von Metallen oder Halbmetallen der 3. Hauptgruppe, 4. Hauptgruppe und/oder 4. Nebengruppe,
C) 1,5 Gew.-% bis 6 Gew.-%, insbesondere 4 bis 6 Gew.-%, PMMI-Copolymer und
D) optional bis zu 10,0 Gew.-% einem oder mehreren von den Komponenten B und C verschiedenen, weiteren Additiven, ausgewählt aus der Gruppe, bestehend aus Flammschutzmitteln, Antitropfmitteln, Schlagzähmodifikatoren, von Komponente B verschiedenen Füllstoffen, Antistatika, Farbmitteln, Pigmenten, Ruß, Gleit- und/oder Entformungsmitteln, Thermostabilisatoren, Verträglichkeitsvermittlern, UV-Absorbern und/oder IR-Absorbern.

Bei den als bevorzugt beschriebenen Ausführungsformen beträgt besonders bevorzugt im PMMI-Copolymer der Anteil an Methylmethacrylimid-Einheiten mindestens 30 Gew.-%, der Anteil an Methylmathacrylat-Einheiten 3 bis 65 Gew.-% und der Anteil an Methylmethacrylsäure- und Methylmethacrylanhydrid-Einheiten in Summe bis zu 15 Gew.-%, jeweils bezogen auf das Gesamtgewicht des in der Zusammensetzung enthaltenen PMMI-Copolymers, und die Säurezahl, bestimmt nach DIN 53240-1:2013-06, 15 bis 50 mg, ganz besonders bevorzugt 20 bis 45 mg KOH/g.

Die Herstellung der erfindungsgemäßen Polymer-Zusammensetzungen, enthaltend die vermischten Komponenten A), B), C) und ggf. D) sowie ggf. weitere Bestandteile, kann unter Verwendung von Pulvervormischungen erfolgen. Es können auch Vormischungen aus Granulaten oder Granulaten und Pulvern mit den erfindungsgemäßen Zusätzen verwendet werden. Es können auch Vormischungen verwendet werden, die aus Lösungen der Mischungskomponenten in geeigneten Lösungsmitteln, wobei gegebenenfalls in Lösung homogenisiert wird und das Lösungsmittel anschließend entfernt wird, hergestellt worden sind. Insbesondere können die als Komponente D bezeichneten Additive und auch weitere Bestandteile der erfindungsgemäßen Zusammensetzungen durch bekannte Verfahren oder als Masterbatch eingebracht werden. Die Verwendung von Masterbatchen ist insbesondere zum Einbringen von Additiven und weiteren Bestandteilen bevorzugt, wobei insbesondere Masterbatche auf Basis der jeweiligen Polymermatrix verwendet werden.

Die erfindungsgemäßen Zusammensetzungen können beispielsweise extrudiert werden. Nach der Extrusion kann das Extrudat abgekühlt und zerkleinert werden. Die Zusammenführung und Durchmischung einer Vormischung in der Schmelze kann auch in der Plastifiziereinheit einer Spritzgussmaschine erfolgen. Hierbei wird die Schmelze im anschließenden Schritt direkt in einen Formkörper überführt.

Es hat sich insbesondere herausgestellt, dass die erfindungsgemäßen Zusammensetzungen besonders geeignet sind für die Herstellung von Extrudaten, bevorzugt für die Extrusion von Profilen und Platten.

Zudem ist auch der Einsatz der Zusammensetzungen als Gehäusematerial im E/E-Bereich, etwa für Stromzähler, mobile Elektronikgeräte (Handy, Laptop, Tablet, etc.) möglich, ebenso für TV-Gehäuse, sowie als Material, insbesondere als Gehäusematerial, für Geräte für den Haushalt (Staubsauger, Klimageräte, Rasierer, etc.).

Da beispielsweise SiO₂ und Al₂O₃ eine gewisse thermische Leitfähigkeit aufweisen und in den Kunststoffkörper einbringen, ist der Bereich der Wärmesenken ein weiteres Anwendungsfeld für erfindungsgemäße Zusammensetzungen.

Die erfindungsgemäßen Zusammensetzungen sind auch für Anwendungen geeignet, die eine hohe Oberflächenqualität und/oder eine hohe Dimensionsstabilität erfordern, z.B. für Platinen im Elektronenbereich oder für Reflektoren. Bei solchen Anwendungen, bei denen ein niedriger thermischer Ausdehnungskoeffizient erforderlich ist, werden hohe Mengen an Füllstoff eingesetzt und eine gute Stabilisierung ist besonders wichtig.

In Polycarbonatzusammensetzungen, die hohe Reflektivitäten aufweisen müssen, also reflective white-Typen, wird Titandioxid eingesetzt. Solche Zusammensetzungen finden beispielsweise eine Einsatzmöglichkeit in optischen Anwendungen, z.B. als Hintergrundmaterial für Displays oder Lichtleiter oder LED-Systeme wie etwa im Smartphone. Die erfindungsgemäßen Zusammensetzungen sind auch als Matrixmaterial für die Composite-Herstellung geeignet. Composite werden hierbei verstanden als Verbundwerkstoffe aus einem Matrixmaterial und einem anorganischen Fasermaterial, insbesondere Glasfasern, Carbonfasern etc.

Eine Stabilisierung mittels PMMI-Copolymer von Polycarbonat-Zusammensetzungen ist insbesondere da bevorzugt, wo hohe Verweilzeiten, d.h. Verweilzeiten von bis zu mehreren Minuten, vorliegen, d.h. beispielsweise bei Ko-Knetern.

### Beispiele:

### Polymere:

**PC1:** Ein kommerziell erhältliches Polycarbonat auf Basis von Bisphenol A mit einer MVR von 19 cm³/10 min (300°C/1,2 kg, ISO 1133-1:2011) und einer Vicat-Erweichungstemperatur (VST/B 120; ISO 306:2013) von 145°C (Makrolon® 2408 der Covestro Deutschland AG). M_{w}, bestimmt, wie nachfolgend beschrieben, ca. 23.900 g/mol.

**PC2:** Ein kommerziell erhältliches Copolycarbonat auf Basis von Bisphenol A und Bisphenol TMC mit einem MVR von 18 cm³/10 min (330°C/2,16 kg, ISO 1133-1:2011) und einer Erweichungstemperatur (VST/B 120; ISO 306:2013) von 183°C (Apec® 1895 von Covestro Deutschland AG). Mw, bestimmt, wie nachfolgend beschrieben, ca. 27.900 g/mol.

### Stabilisatoren:

**PMMI1:** Polymethacrylmethylimid-Copolymer der Firma Evonik (Pleximid® 8803) mit einer Erweichungstemperatur (VST/B 50; ISO 306:2013) von 130°C. Säurezahl: 22,5 mg KOH/g, bestimmt nach DIN 53240-1:2013-06. Anteil MMI (Methylmethacrylimid): 36,8 Gew.-%, Anteil MMA (Methylmathacrylat): 51,7 Gew.-%, Anteil MMS (Methylmethacrylsäure) + MMAH (Methylmethacrylanhydrid): 11,5 Gew.-%, jeweils bezogen auf das Gesamtgewicht des PMMI und ermittelt mittels quantitativer ¹H-NMR-Spektroskopie.

**PMMI2:** Polymethacrylmethylimid-Copolymer der Firma Evonik (Pleximid® TT50) mit einer Erweichungstemperatur (VST/B 50; ISO 306:2013) von 150°C. Säurezahl: 22,5 mg KOH/g, bestimmt nach DIN 53240-1:2013-06. Anteil MMI: 83,1 Gew.-%, Anteil MMA: 13,6 Gew.-%, Anteil MMS + MMAH: 3,3 Gew.-%, jeweils bezogen auf das Gesamtgewicht des PMMI und ermittelt mittels quantitativer ¹H-NMR-Spektroskopie.

**PMMI3:** Polymethacrylmethylimid-Copolymer der Firma Evonik (Pleximid® TT70) mit einer Erweichungstemperatur (VST/B 50; ISO 306:2013) von 170°C. Säurezahl: 41,5 mg KOH/g, bestimmt nach DIN 53240-1:2013-06. Anteil MMI: 94,8 Gew.-%, Anteil MMA: 4,6 Gew.-%, Anteil MMS + MMAH: 0,6 Gew.-%, jeweils bezogen auf das Gesamtgewicht des PMMI und ermittelt mittels quantitativer ¹H-NMR-Spektroskopie.

**Stab1:** Ein Maleinsäureanhydrid-modifiziertes Ethylen-Propylen-1-Octen-Terpolymer-Wachs (Ethen:Propen:1-Octen 87:6:7, Gewichtsverhältnis) der Firma Mitsui Chemical America, Inc. (Hiwax™ 1105A) mit einem mittleren Molekulargewicht (Gelpermeationschromatographie in ortho-Dichlorbenzol bei 150 °C mit Polystyrolkalibrierung) M_{w} = 6301 g/mol, Mₙ = 1159 g/mol und mit einer Säurezahl von 52,6 mg KOH/g (Testmethode JIS K0070). Maleinsäureanhydridanteil: 4,4 Gew.-%, bezogen auf das Gesamtgewicht des Terpolymers.

**Stab2:** Ein Maleinsäureanhydrid-modifiziertes Polypropylen-Copolymer der Firma Honeywell (AC907P) mit einem mittleren Molekulargewicht (Gelpermeationschromatographie in ortho-Dichlorbenzol bei 150 °C mit Polystyrolkalibrierung) M_{w} = 20.700 g/mol, Mₙ = 1460 g/mol und mit einer Säurezahl von 78 mg KOH/g (ASTM D-1386)).

### Füllstoffe:

**F1:** Titandioxid der Firma Kronos mit einem D₅₀ = 210 nm (Rasterelektronenmikroskopie, ECD-Methode; Kronos® 2230).

**F2:** Quarzgut der Firma Quarzwerke GmbH (50226 Frechen, Deutschland), welches unter dem Handelsnamen Amosil FW600 verfügbar ist (D₅₀ = 4 µm, D₉₈ = 13 µm, unbeschlichtet). Es handelt sich um ein gebranntes Siliciumdioxid mit einem D₁₀/D₉₀-Verhältnis von ca. 1,5/10, ermittelt nach ISO 13320:2009, sowie einer spezifischen Oberfläche von ca. 6 m²/g, ermittelt nach DIN-ISO 9277:2014-01.

**F3:** Aluminiumoxid der Firma Fluka mit einem pH-Wert von 7.2, gemessen bei Raumtemperatur mit einem pH-Meter der Firma Mettler Toledo (MP230), gemessen nach ISO 10390:2005 in wässriger Suspension.

### Herstellungsparameter:

### Methode A ^{[1]}:

Als Extruder wurde ein DSM Micro-Extruder MIDI 2000 mit einer Kapazität von 15 cm³ verwendet. Die Massetemperatur im Extruder betrug 280 °C, die Drehzahl 150 U/min und die Verweilzeit (VWZ) war 5 Minuten bzw. 10 Minuten. Für den Spritzguss wurde eine DSM Spritzgussmaschine verwendet. Die Massetemperatur beim Spritzguss betrug: 300°C, die Werkzeugtemperatur 80°C.

### Methode B ^{[2]}:

Als Extruder wurde ein Zweiwellenextruder ZE 25 AX 40D-UTX der Firma KraussMaffei Berstorff verwendet. Die Massetemperatur im Extruder betrug 300 °C, die Drehzahl 100 U/min und der Durchsatz 10 kg/h. Das Drehmoment betrug 15 bis 40%. Die Füllstoffdosierung erfolgte über den Seitenextruder an Gehäuse 5 (von 9).

### Bestimmungsmethoden:

**M_{w}:** Gelpermeationschromatographie, kalibriert gegen Bisphenol A-Polycarbonat-Standards, unter Verwendung von Dichlormethan als Elutionsmittel. Kalibrierung mit linearen Polycarbonaten (aus Bisphenol A und Phosgen) bekannter Molmassenverteilung der PSS Polymer Standards Service GmbH, Deutschland, Kalibrierung nach der Methode 2301-0257502-09D (aus dem Jahre 2009 in deutscher Sprache) der Currenta GmbH & Co. OHG, Leverkusen. Das Elutionsmittel ist Dichlormethan. Säulenkombination aus vernetzten Styrol-Divinylbenzolharzen. Durchmesser der analytischen Säulen: 7,5 mm; Länge: 300 mm. Partikelgrößen des Säulenmaterials: 3 µm bis 20 µm. Konzentration der Lösungen: 0,2 Gew.-%. Flussrate: 1,0 ml/min, Temperatur der Lösungen: 30°C. Injektvolumen; 100 µl. Detektion mittels UV-Detektor.

Der **Yellowness Index** (Y.I.) wurde gemessen nach ASTM E313-10. Die Transmissionswerte (**Ty**) wurden bestimmt nach ASTM-E-308, die **Reflektivität** wurde nach ASTM E 1331 gemessen. Sowohl Y.I. als auch Ty und Reflexion Ry wurden nach D65,10° (Lichtart: D65/Beobachter: 10°) ausgewertet. Der **Glanz** wurde gemessen nach ASTM D 523 Hunter UltraScanPRO, diffus/8° (Referenz: Keramik Absolutwerte). Die **Farbwerte (L*a*b)** wurden nach DIN EN ISO 11664-4:2012-06 gemessen. Die Proben hatten eine Geometrie von 6,0 mm x 3,5 mm x 1,5 mm.

Die **Viskosität** der Polymerschmelzen wurde nach ISO 11443:2005 bei einer Schmelzetemperatur von 300°C und einer Scherrate von 1000 s⁻¹ gemessen.

Die **Vicat-Erweichungstemperatur** (VST/B/50) der Zusammensetzungen wurde gemessen an Prüfkörpern nach ISO 306:2013.

Das **Zugmodul** und die **Zugfestigkeit** der Zusammensetzungen wurden gemessen an Prüfkörpern nach ISO 527-1:2012.

Die **Durchstoßkraft** und **-verformung** der Zusammensetzungen wurden gemessen an Prüfkörpern nach ISO 6603-2:2000.

### Ergebnisse:

### Beispiele:

**Tabelle 1: Füllstoff-freies Polycarbonat^{[1]} und der Einfluss von PMMI**

| | | **1V** | **2V** | **3V** | **4V** | **5V** | **6V** | **7V** |
|---|---|---|---|---|---|---|---|---|
| | | **Gew.-%** | **Gew.-%** | **Gew.-%** | **Gew.-%** | **Gew.-%** | **Gew.-%** | **Gew.-%** |
| **PC1** | | 100 | 99,8 | 99,5 | 99 | 98 | 96 | 94 |
| **PMMI1** | | | 0,2 | 0,5 | 1 | 2 | 4 | 6 |
| | **VWZ** | | | | | | | |
| **M_{w} [g/mol]** | 5 Min | 23365 | 23408 | 23395 | 23409 | 23493 | 23554 | 23689 |

| | | | | | | | | |
|---|---|---|---|---|---|---|---|---|
| [1] Die Zusammensetzungen wurden nach Methode A hergestellt | | | | | | | | |

In ungefülltem Polycarbonat kommt es zu keinem wesentlichen Abbau der Polymerketten. Ein Stabilisator ist daher nicht erforderlich. Wie sich aus Tabelle 1 erkennen lässt, hat der Zusatz von PMMI zu Füllstoff-freiem Polycarbonat keinen negativen Einfluss auf das Molekulargewicht. Die mittleren Molekulargewichte sind auf einem im Rahmen der Messgenauigkeit konstanten Niveau.

**Tabelle 2: Füllstoff-freies Polycarbonat ^{[1]} und der Einfluss von PMMI**

| | **8V** | **9V** | **10V** |
|---|---|---|---|
| | **Gew.-%** | **Gew.-%** | **Gew.-%** |
| **PC1** | 99 | 99 | 99 |
| **PMMI1** | 1 | | |
| **PMMI2** | | 1 | |
| **PMMI3** | | | 1 |
| | | | |
| **Mw [g/mol]** | 23595 | 23687 | 23819 |
| **Viskosität [Pa • s]** | 214 | 198 | 183 |
| **Vicat- Temperatur [°C]** | 146,8 | 146,7 | 147,1 |
| **Zugmodul [MPa]** | 2261 | 2212 | 2241 |
| **Zugfestigkeit [MPa]** | 69,3 | 71,6 | 70 |
| **Durchstoß, Maximalkraft [N]** | 5238 | 5218 | 5178 |
| **Durchstoß, Verformung [mm]** | 19,8 | 19,5 | 19,0 |

| | | | |
|---|---|---|---|
| [1] Die Zusammensetzungen wurden nach Methode B hergestellt. | | | |

In ungefülltem Polycarbonat verhalten sich die drei eingesetzten PMMI-Typen nahezu identisch. Die Zugabe von 1 Gew.-% PMMI-Copolymer wirkt sich nur minimal auf die Vicat-Temperatur aus. Der Einfluss der unterschiedlichen Erweichungstemperaturen der verschiedenen PMMI-Copolymer-Typen macht sich bei 1 Gew.-% Zusatz allerdings bereits bemerkbar:

**Tabelle 3: Titandioxid-haltige Polycarbonat-Zusammensetzungen^{[1]} und der Einfluss von PMMI-Copolymer**

| | | **11V** | **12** | **13** | **14** | **15** | **16** | **17** |
|---|---|---|---|---|---|---|---|---|
| | | **Gew.-%** | **Gew.-%** | **Gew.-%** | **Gew.-%** | **Gew.-%** | **Gew.-%** | **Gew.-%** |
| **PC1** | | 80 | 79,8 | 79,5 | 79 | 78 | 76 | 74 |
| **F1** | | 20 | 20 | 20 | 20 | 20 | 20 | 20 |
| **PMMI1** | | | 0,2 | 0,5 | 1 | 2 | 4 | 6 |
| | **VWZ** | | | | | | | |
| **M_{w} [g/mol]** | 5 Min | 21300 | 22300 | 22847 | 23008 | 23512 | 23490 | 23588 |
| **Y.I.** | 5 Min | 4,52 | 4,94 | 3,60 | 4,02 | 3,99 | 3,39 | 3,94 |
| **L* (D65, 10°)** | 5 Min | 98,0 | 97,6 | 98,5 | 98,3 | 98,2 | 98,6 | 98,5 |
| **Ry (D65, 10°) [%]** | 5 Min | 94,99 | 93,99 | 96,18 | 95,59 | 95,35 | 96,31 | 96,07 |

| | | | | | | | | |
|---|---|---|---|---|---|---|---|---|
| [1] Die Zusammensetzungen wurden nach Methode B hergestellt. | | | | | | | | |

Die Zugabe von 20 Gew.-% Titandioxid führt zu einem gegenüber reinem Polycarbonat signifikanten Molekulargewichtsabbau des Polycarbonates auf 21.300 g/mol. Schon geringe Mengen PMMI-Copolymer von 0,2 Gew.-% bewirken eine deutliche Reduzierung des Molekulargewichtsabbaus. Bei Zugabe von nur 2 Gew.-% PMMI-Copolymer ist bereits ein Plateaubereich erreicht, bei dem sich die weitere PMMI-Zugabe nicht mehr merklich auswirkt und das Molekulargewicht des Polycarbonats nur minimal unter dem des reinen Polycarbonats verbleibt. Selbst nach 5 Minuten Verweilzeit ist das Molekulargewicht etwa auf dem Niveau des ungefüllten Polycarbonates.

Hinsichtlich der Vergilbung (Y.I.) ist kein signifikanter Unterschied innerhalb der Konzentrationsreihe (0 bis 6 Gew.-% PMMI-Copolymer) festzustellen; von der Tendenz scheint die Vergilbung eher minimal verringert. Der L-Wert ist gegenüber der unstabilisierten Zusammensetzung (Beispiel 11V) nicht verändert und auch die Reflektivität Ry von Titandioxid-gefülltem Polycarbonat wird durch die Zugabe von PMMI-Copolymer nicht beeinflusst.

**Tabelle 4: Titandioxid-haltige Polycarbonat-Zusammensetzungen^{[1]} und der Einfluss unterschiedlicher PMMI-Typen**

| | | **18V** | **19** | **20** | **21** |
|---|---|---|---|---|---|
| | | **Gew.-%** | **Gew.-%** | **Gew.-%** | **Gew.-%** |
| **PC1** | | 80 | 79 | 79 | 79 |
| **F1** | | 20 | 20 | 20 | 20 |
| **PMMI1** | | | 1 | | |
| **PMMI2** | | | | 1 | |
| **PMMI3** | | | | | 1 |
| | **VWZ** | | | | |
| **M_{w} [g/mol]** | 5 Min | 21300 | 23008 | 23024 | 22801 |
| **Y.I. (D65, 10°)** | 5 Min | 4,52 | 4,02 | 4,03 | 3,88 |

| | | | | | |
|---|---|---|---|---|---|
| [1] Die Zusammensetzungen wurden nach Methode A hergestellt. | | | | | |

Die verwendeten PMMI-Copolymer-Typen unterscheiden sich in ihrem Gehalt an MMI, MMA, Säure und Anhydrid. Zwischen den unterschiedlichen PMMI-Copolymeren ist kein relevanter Unterschied bei der Stabilisierung Titandioxid-gefüllter Polycarbonat-Zusammensetzungen feststellbar. Jedes der drei PMMI-Copolymere bewirkt eine gute Stabilisierung. Auch hinsichtlich der Vergilbung ist kein signifikanter Unterschied festzustellen. Der Zusatz von PMMI-Copolymer bewirkt gegenüber der nicht-additivierten Polycarbonatzusammensetzung (Beispiel 18V) eine geringfügige Absenkung des Y.I.-Wertes und somit Verbesserung der Vergilbung.

**Tabelle 5: Vergleich von unterschiedlichen Säure/Maleinsäureanhydrid-funktionalisierten Copolymeren als Stabilisatoren^{[1]}**

| | | **22V** | **23V** | **24V** | **25** | **26V** | **27V** |
|---|---|---|---|---|---|---|---|
| | | **Gew.-%** | **Gew.-%** | **Gew.-%** | **Gew.-%** | **Gew.-%** | **Gew.-%** |
| **PC1** | | 99 | 99 | 99 | 79 | 79 | 79 |
| **F1** | | | | | 20 | 20 | 20 |
| **PMMI1** | | 1 | | | 1 | | |
| **Stab1** | | | 1 | | | 1 | |
| **Stab 2** | | | | 1 | | | 1 |
| | VWZ | | | | | | |
| **M_{w} [g/mol]** | 5 Min | 23409 | 23382 | 23104 | 23008 | 23662 | 23431 |
| **Y.I. (D65, 10°)** | 5 Min | 12,75 | 22,98 | 16,55 | 4,02 | 2,98 | 3,74 |
| **Ty (%)** | 5 Min | 80,9 | 61,8 | 48,3 | -- | -- | -- |

| | | | | | | | |
|---|---|---|---|---|---|---|---|
| [1] Die Zusammensetzungen wurden nach Methode A hergestellt. | | | | | | | |

In Kombination mit Titandioxid als Füllstoff bewirken PMMI1, Stab 1 und Stab 2 eine etwa gleich gute Stabilisierung des Polycarbonats.

In ungefülltem Polycarbonat (Beispiele 22V bis 24V) ist der Y.I.-Wert bei Zusatz von PMMI-Copolymer gegenüber Polycarbonat mit den Stabilisatoren Stab1 und Stab 2 deutlich verringert, d.h. die Vergilbung ist niedriger. Stab1 und Stab 2 bewirken gegenüber dem PMMI-Copolymer eine stärkere Eintrübung, erkennbar an der Abnahme der Transmission auf 61 bzw. 48%.

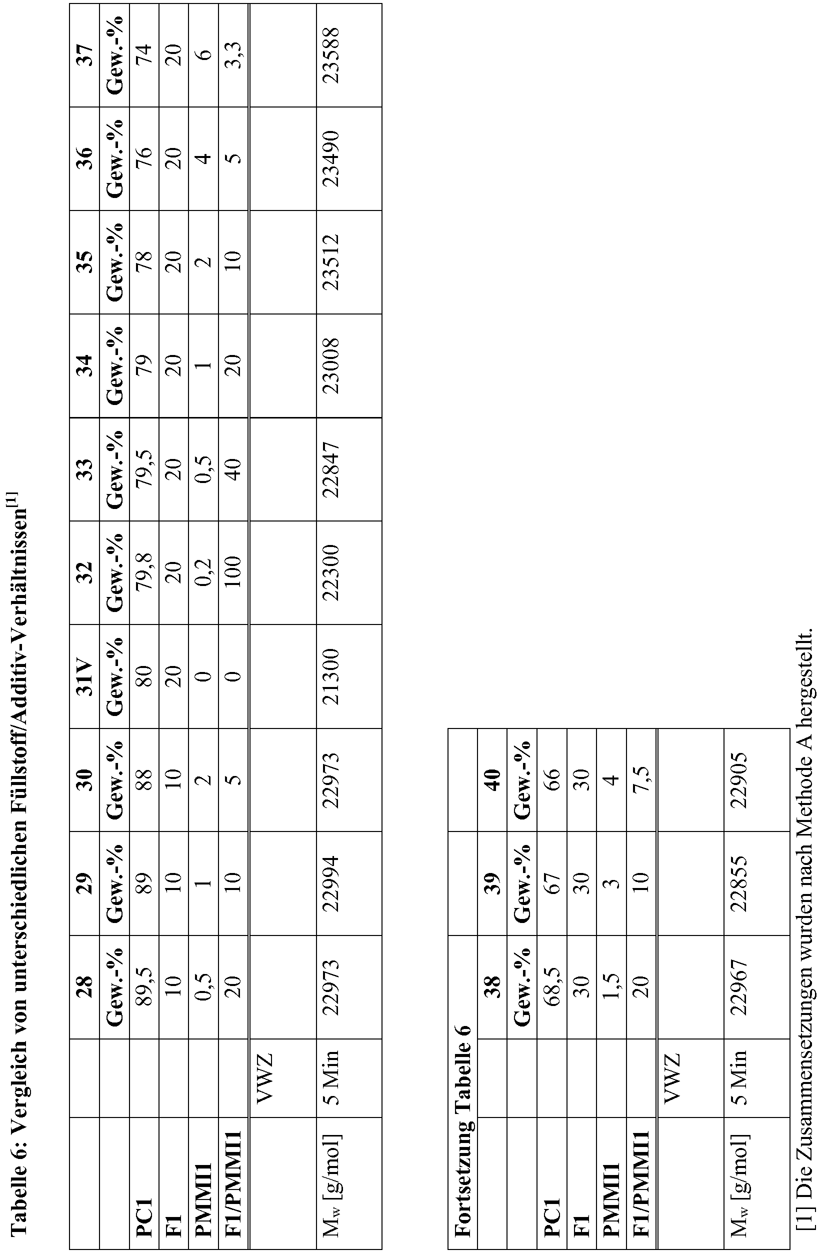

Titandioxid-gefülltes PC hat bei 10 bis 30 Gew-% Füllstoff eine maximal erreichbare Stabilisierungsgrenze. Diese liegt etwa zwischen 23.000-23.500 g/mol. Ab etwa 0,5 Gew.-% PMMI-Copolymer ändert sich das Molekulargewicht nicht mehr signifikant.

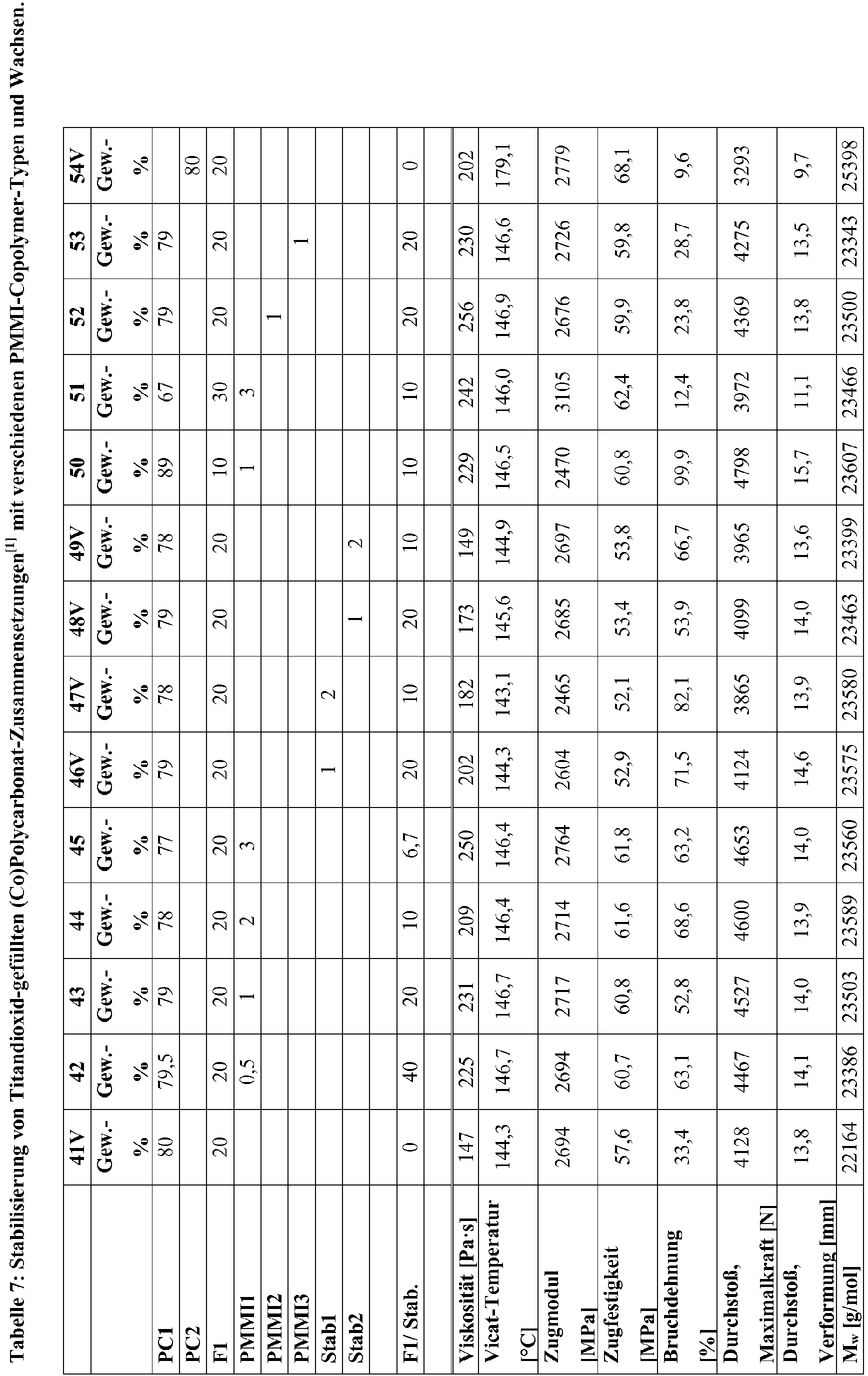

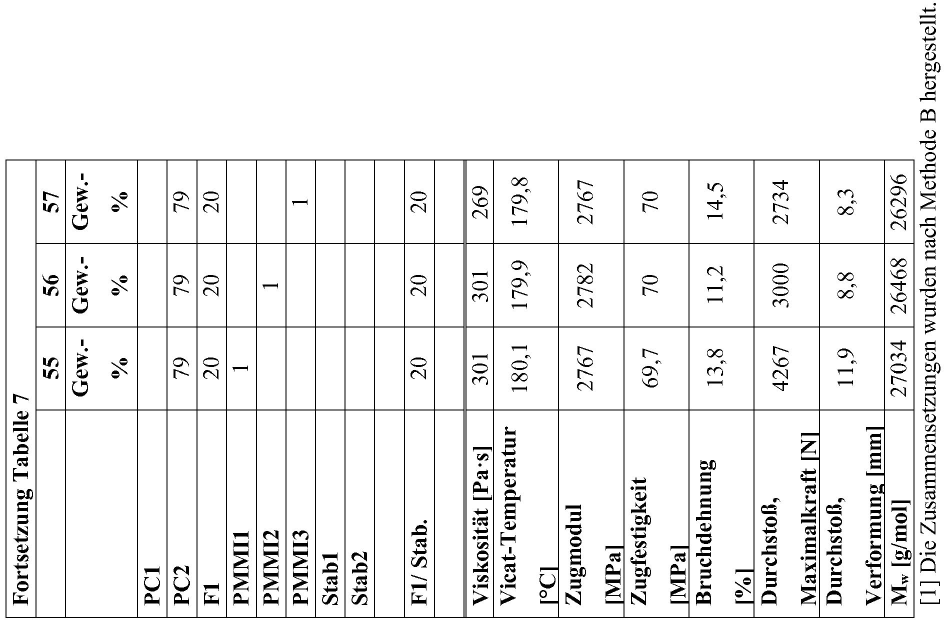

Die PMMI-Copolymer-Typen 2 und 3 ergeben in Bisphenol-A-basiertem Polycarbonat eine deutlich schlechtere Bruchdehnung, d.h. Zähigkeit, als das PMMI-Copolymer I (vgl. Beispiele 52, 53 mit 43), die aber immer noch in einem guten Bereich liegt. Bei dem Polycarbonat-Copolymer PC-2 als Basismaterial lässt sich hinsichtlich der Bruchdehnung zwischen den eingesetzt PMMI-Copolymer-Typen kein nennenswerter Unterschied feststellen (Beispiele 55 bis 57). Bei 1 Gew.-% PMMI-Copolymer ist aber schon ein deutlicher Effekt auf die Molekulargewichtsstabilisierung erkennbar, was bei größeren Mengen PMMI-Copolymer noch stärker ausgeprägt sein dürfte. Verglichen mit einer nicht-additivierten Zusammensetzung (Bsp. 54V) bewirkt der Zusatz von nur 1 Gew.-% PMMI1 auch bei PC-2 ein erheblich verbessertes Impact-Verhalten und eine erhöhte Bruchdehnung (Bsp. 55). Alle drei PMMI-Copolymer-Typen erhöhen bei PC-2 die Zähigkeit bei gleichbleibender Festigkeit/Steifigkeit (vgl. Bsp. 54 V mit Bsp. 55-57).

Die Stabilisierung mit Stab1 und Stab2 in gleichen Mengen (1 bzw. 2 Gew.-%) wie bei dem PMMI-Copolymer 1 zum Vergleich wirkt sich auf die Reduzierung des Molekulargewichtsabbaus vergleichbar aus. Die Zusammensetzungen, die die Polyolefin-Systeme Stab1 bzw. Stab2 enthalten, zeigen jedoch eine relevante Absenkung der Vicat-Temperatur. Zudem sind insgesamt die mechanischen Eigenschaften gegenüber einer Zusammensetzung mit PMMI-Copolymer schlechter; das Zugmodul und die Zugfestigkeit sind reduziert. Bei Zusatz von Stab1 und Stab2 ergibt sich zudem ein signifikant schlechteres Impact-Verhalten (gemessen an der erreichbaren Maximalkraft im Durchstoßversuch) als bei Zusatz von PMMI1 (Bsp. 46V-49V im Vergleich zu Bsp. 43, 44).

**Tabelle 8: Gebranntes Siliciumdioxid-haltige Polycarbonat-Zusammensetzungen^{[1]} und der Einfluss von PMMI-Copolymer**

| | | **58V** | **59** | **60** | **61** | **62** | **63** | **64** |
|---|---|---|---|---|---|---|---|---|
| | | **Gew.-%** | **Gew.-%** | **Gew.-%** | **Gew.-%** | **Gew.-%** | **Gew.-%** | **Gew.-%** |
| **PC1** | | 80 | 79,8 | 79,5 | 79 | 78 | 76 | 74 |
| **F2** | | 20 | 20 | 20 | 20 | 20 | 20 | 20 |
| **PMMI1** | | | 0,2 | 0,5 | 1 | 2 | 4 | 6 |
| | VWZ | | | | | | | |
| **M_{w} [g/mol]** | 5 Min | 22299 | nicht getestet | | | 23388 | 23556 | 23581 |
| **M_{w} [g/mol]** | 10 Min | 21424 | | | | 23582 | 23513 | 23523 |

| | | | | | | | | |
|---|---|---|---|---|---|---|---|---|
| [1] Die Zusammensetzungen wurden nach Methode A hergestellt. | | | | | | | | |

Das hier verwendete gebrannte Siliciumdioxid ist im Vergleich zu anderen anorganischen Füllstoffen besser verträglich mit Polycarbonat, ersichtlich am geringeren Molekulargewichtsabbau von nur ca. 1000 g/mol ohne zusätzlichen Stabilisator. Der leicht saure Charakter des Siliciumdioxids hat eine weniger stark ausgeprägte Unverträglichkeit mit Polycarbonat. Allerdings kann auch hier noch ein stabilisierender Effekt durch Zugabe von PMMI-Copolymer erzielt werden, wobei spätestens bei etwa 2 Gew.-% ein Plateaubereich erreicht wird. Höhere Konzentrationen von 4-6% führen zu keiner weiteren Verbesserung.

Besonders bei höherer Verweilzeit von 10 Minuten ist diese Stabilisierung immer noch wirksam und das Molekulargewicht ist auf dem Niveau von ungefülltem PC. Während ohne PMMI-Copolymer das Molekulargewicht um weitere 1000 g/mol reduziert wird (Beispiel 58V), bleiben die Molekulargewichte der additivierten Compounds (Beispiele 62-64) unverändert.

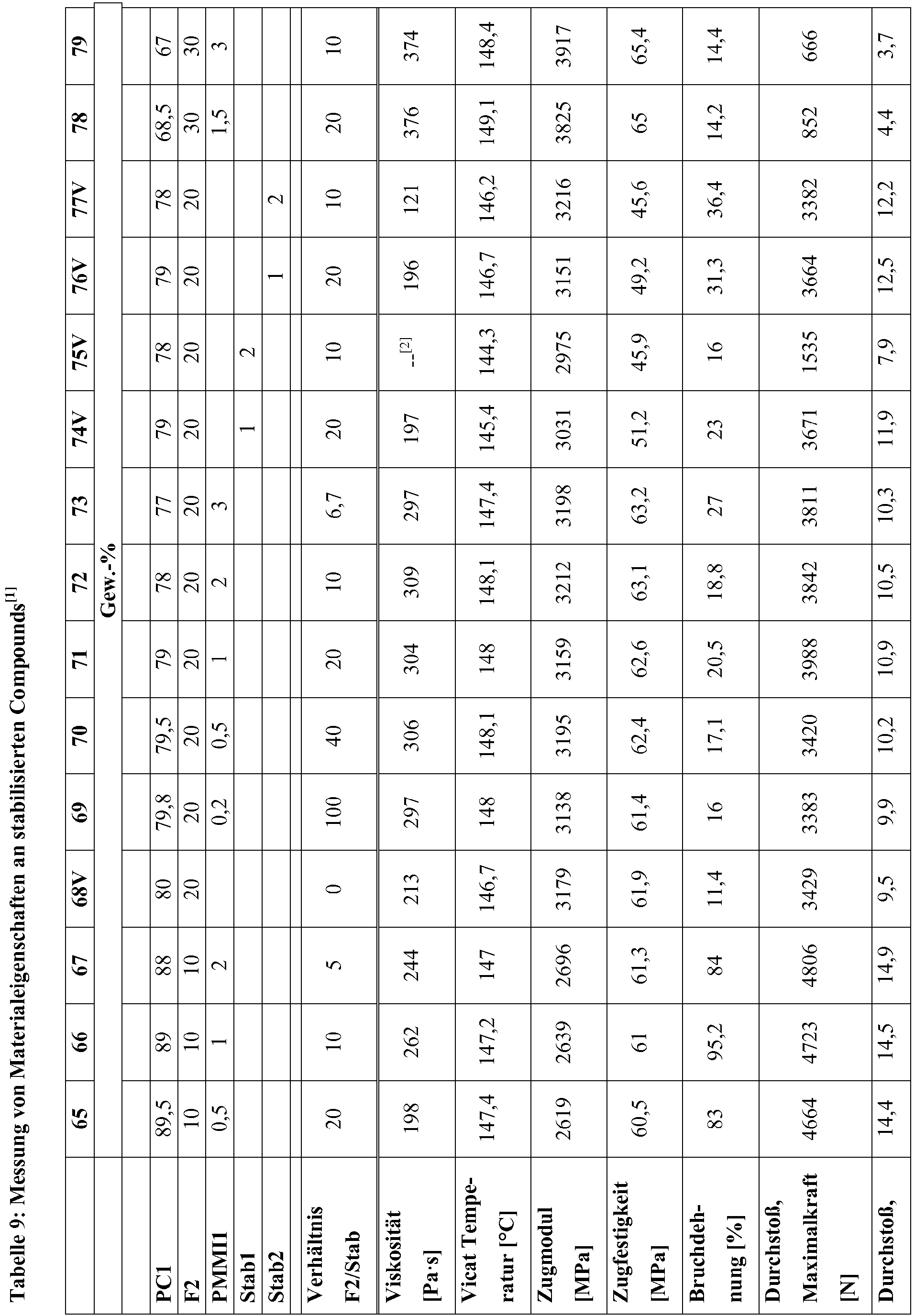

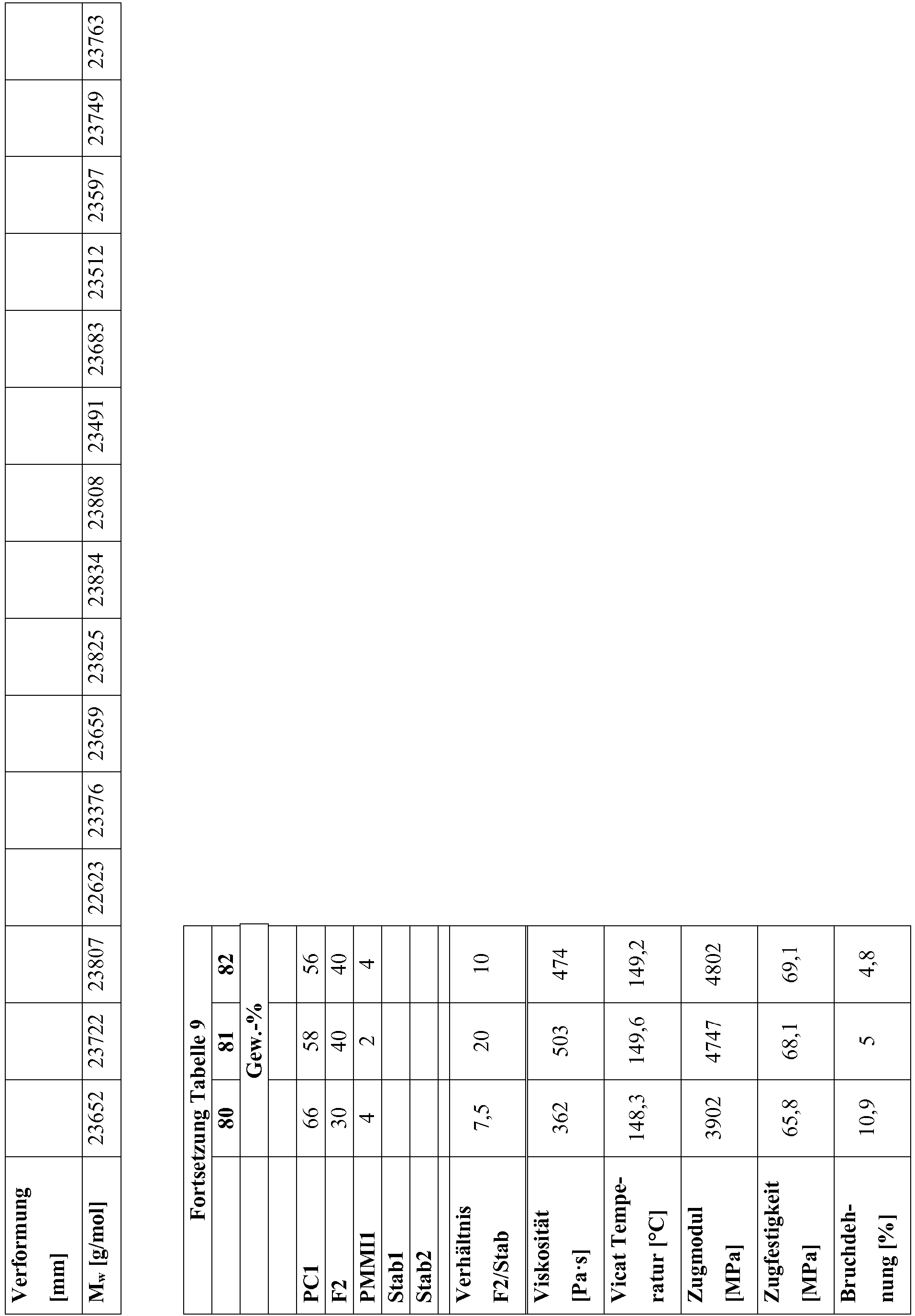

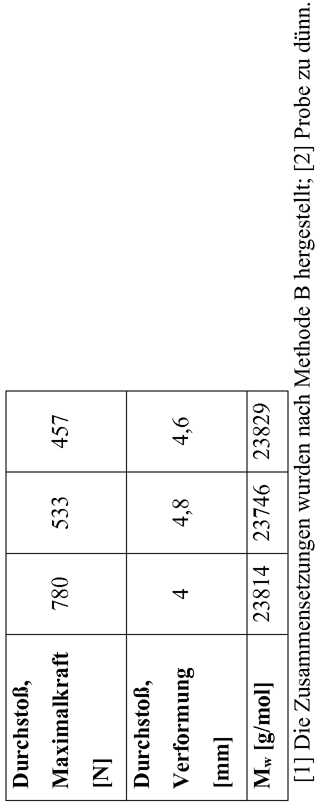

Bei Zusatz des Wachses Stab1 ist das Zugmodul leicht verringert (Beispiele 74V, 75V) gegenüber solchen Zusammensetzungen, denen PMMI-Copolymer zugesetzt wurde (Beispiele 71, 72). Die Zugfestigkeit bleibt bei Zusatz von PMMI-Copolymer etwa konstant bzw. nimmt leicht zu (Beispiele 69 bis 73). wohingegen sie bei Zugabe von Stab1 oder Stab2 deutlich abnimmt. Während der Füllstoff an sich zunächst eine verstärkende Wirkung hat, geht dieses durch Stab1 und Stab2, die zwar stabilisierend wirken, teilweise wieder verloren; Stab1 und Stab2 haben eine weichmachende Wirkung. Die Vicat-Temperatur ist auch signifikant erniedrigt (Bsp. 71, 72 mit 74V-77V). Das PMMI-Copolymer bewirkt im Vergleich zu Stab1 und Stab2 auch eine leicht bessere Stabilisierung (Bsp. 71, 72 mit 74V-77V). Ab einer Zugabemenge von etwa 1 Gew.-% wird ein Plateaubereich erreicht.

Bei den Zusammensetzungen, enthaltend 10 Gew.-% gebranntes Siliciumdioxid und PMMI-Copolymer (Beispiele 65 bis 67), liegen sehr hohe Bruchdehnungen vor.

**Tabelle 10: Gebranntes Siliciumdioxid-haltige Polycarbonat-Zusammensetzungen^{[1]} und der Einfluss unterschiedlicher PMMI-Typen**

| | **83** | **84** | **85** |
|---|---|---|---|
| | **Gew.-%** | | |
| **PC1** | 79 | 79 | 79 |
| **F2** | 20 | 20 | 20 |
| **PMMI1** | 1 | | |
| **PMMI2** | | 1 | |
| **PMMI3** | | | 1 |
| **Viskosität [Pa·s]** | 304 | 291 | 294 |
| **Vicat- Temperatur [°C]** | 148 | 148,3 | 148,2 |
| **Zugmodul [MPa]** | 3159 | 3207 | 3202 |
| **Zugfestigkeit [MPa]** | 62,6 | 62,7 | 62,4 |
| **Durchstoß, Maximalkraft [N]** | 3988 | 4013 | 3690 |
| **Durchstoß, Verformung [mm]** | 10,9 | 11 | 10,4 |
| **Mw (g/mol)** | 23825 | 23436 | 23253 |

| | | | |
|---|---|---|---|
| [1] Die Zusammensetzungen wurden nach Methode B hergestellt. | | | |

Die Beispiele 83 bis 85 zeigen, dass bei Siliciumdioxid-haltigen Zusammensetzungen das PMMI-Copolymer mit dem geringsten Imid-Anteil (PMMI1) am stärksten stabilisierend gegen einen Molekulargewichtsabbau wirkt. PMMI2 erzielt die beste Mechanik (Zug, Durchstoß) sowie die beste Vicat-Temperatur, und das bei der besten Fließfähigkeit, d.h. niedrigsten Viskosität.

**Tabelle 11: Aluminiumoxid-gefüllte Zusammensetzungen^{[1]} und der Einfluss von PMMI-Copolymer**

| | | **86V** | **87** |
|---|---|---|---|
| | | **Gew.-** | **Gew.-%** |
| **PC1** | | 90 | 89 |
| **F3** | | 10 | 10 |
| **PMMI1** | | | 1 |
| | VWZ | | |
| **M_{w}** | 5 | 15844 | 19321 |

| | | | |
|---|---|---|---|
| [1] Die Zusammensetzungen wurden nach Methode A hergestellt. | | | |

Der Abbau durch 10 Gew.-% Al₂O₃ bei einer Verweilzeit von 5 min ist bereits sehr stark ausgeprägt, kann aber bereits durch Einsatz von nur 1% PMMI-Copolymer deutlich reduziert werden.

## Patentansprüche

1. Verwendung mindestens eines Polymethacrylmethylimid-Copolymers (PMMI-Copolymers) zur Reduzierung des Molekulargewichtsabbaus von aromatischem Polycarbonat bei Polycarbonat-Zusammensetzungen, enthaltend ein oder mehrere Oxide von Metallen oder Halbmetallen der 3. Hauptgruppe, 4. Hauptgruppe und/oder 4. Nebengruppe, beim Compoundieren.

2. Verwendung gemäß Anspruch 1, wobei das PMMI-Copolymer 3 bis 65 Gew.-% Methylmathacrylat-Einheiten, mindestens 30 Gew.-% Methylmethacrylimid-Einheiten, in Summe bis zu 15 Gew.-% Methylmethacrylsäure-Einheiten und Methylmethacrylanhydrid-Einheiten, jeweils bezogen auf das Gesamtgewicht des PMMI-Copolymers, und eine Säurezahl, bestimmt nach DIN 53240-1:2013-06, von 15 bis 50 mg KOH/g aufweist.

3. Zusammensetzung, enthaltend
A) aromatisches Polycarbonat,
B) ein oder mehrere Oxide von Metallen oder Halbmetallen der 3. Hauptgruppe, 4. Hauptgruppe und/oder 4. Nebengruppe,
C) PMMI-Copolymer und
D) optional weitere Additive.

4. Zusammensetzung nach Anspruch 3, wobei die Zusammensetzung
A) mindestens 55 Gew.-% aromatisches Polycarbonat,
B) 5 bis 44 Gew.-% ein oder mehrere Oxide von Metallen oder Halbmetallen der 3. Hauptgruppe, 4. Hauptgruppe und/oder 4. Nebengruppe,
C) 0,1 bis 8 Gew.-% PMMI-Copolymer und
D) optional weitere Additive
enthält.

5. Zusammensetzung nach Anspruch 3 oder 4, wobei die Zusammensetzung
A) mindestens 56 Gew.-% aromatisches Polycarbonat,
B) 10 bis 35 Gew.-% ein oder mehrere Oxide von Metallen oder Halbmetallen der 3. Hauptgruppe, 4. Hauptgruppe und/oder 4. Nebengruppe,
C) 0,2 bis 6 Gew.-% PMMI-Copolymer und
D) optional weitere Additive
enthält.

6. Zusammensetzung nach einem der Ansprüche 3 bis 5, bestehend aus
A) mindestens 60 Gew.-% aromatischem Polycarbonat,
B) 10 bis 30 Gew.-% einem oder mehreren Oxiden von Metallen oder Halbmetallen der 3. oder 4. Hauptgruppe oder 4. Nebengruppe,
C) 0,2 bis 6 Gew.-% PMMI-Copolymer und
D) optional ein oder mehreren von den Komponenten B und C verschiedenen, weiteren Additiven, ausgewählt aus der Gruppe, bestehend aus Flammschutzmitteln, Antitropfmitteln, Schlagzähmodifikatoren, Füllstoffen, Antistatika, Farbmitteln, Pigmenten, Ruß, Gleit- und/oder Entformungsmitteln, Thermostabilisatoren, Blendpartner, Verträglichkeitsvermittlern, UV-Absorbern und/oder IR-Absorbern.

7. Zusammensetzung nach einem der Ansprüche 3 bis 6, wobei die Zusammensetzung mindestens 1,5 Gew.-% PMMI-Copolymer enthält, bezogen auf die Gesamtzusammensetzung.

8. Zusammensetzung nach einem der Ansprüche 3 bis 7, wobei die Zusammensetzung 15 bis 25 Gew.-% ein oder mehrere Oxide von Metallen oder Halbmetallen der 3. Hauptgruppe, 4. Hauptgruppe und/oder 4. Nebengruppe und mindestens 1,0 Gew.-% PMMI-Copolymer enthält.

9. Zusammensetzung nach einem der Ansprüche 3 bis 8 oder Verwendung nach Anspruch 1, wobei das PMMI-Copolymer Methylmathacrylat-Einheiten, Methylmethacrylimid-Einheiten, Methylmethacrylsäure-Einheiten und Methylmethacrylanhydrid-Einheiten aufweist.

10. Zusammensetzung nach einem der Ansprüche 3 bis 9 oder Verwendung nach Anspruch 1 oder 9, wobei der Anteil an Methylmethacrylimid-Einheiten mindestens 30 Gew.-%, der Anteil an Methylmathacrylat-Einheiten 3 bis 65 Gew.-% und der Anteil an Methylmethacrylsäure- und Methylmethacrylanhydrid-Einheiten in Summe bis zu 15 Gew.-% beträgt, jeweils bezogen auf das Gesamtgewicht des in der Zusammensetzung enthaltenen PMMI-Copolymers.

11. Zusammensetzung nach einem der Ansprüche 3 bis 10 oder Verwendung nach einem der Ansprüche 1, 9 oder 10, wobei die Säurezahl des PMMI-Copolymers, bestimmt nach DIN 53240-1:2013-06, 15 bis 50 mg KOH/g beträgt.

12. Zusammensetzung nach einem der Ansprüche 3 bis 11 oder Verwendung nach einem der Ansprüche 1, 9, 10 oder 11, wobei der Anteil an Oxiden von Metallen oder Halbmetallen der 3. Hauptgruppe, 4. Hauptgruppe und/oder 4. Nebengruppe 15 bis 25 Gew.-%, bezogen auf die Gesamtzusammensetzung, ist und das Verhältnis von Oxiden von Metallen oder Halbmetallen der 3. Hauptgruppe, 4. Hauptgruppe und/oder 4. Nebengruppe zu PMMI-Copolymer ≤ 40 ist.

13. Zusammensetzung nach einem der Ansprüche 3 bis 12 oder Verwendung nach einem der Ansprüche 1 oder 9 bis 12, wobei der der Anteil PMMI-Copolymer in der fertigen Zusammensetzung 2 bis 6 Gew.-% beträgt.

14. Formteil aus einer oder umfassend Bereiche aus einer Zusammensetzung nach einem der Ansprüche 3 bis 13.

15. Formteil nach Anspruch 14, wobei das Formteil ein Profil, eine Platte, ein Gehäuseteil im Elektro/Elektronik-Bereich, eine Wärmsenke, ein Reflektor, eine Platine im Elektronikbereich, ein Element für eine optische Anwendung, ein Composite ist.

## Claims

1. Use of at least one polymethylmethacrylimide copolymer (PMMI copolymer) for reducing the molecular weight degradation of aromatic polycarbonate in polycarbonate compositions containing one or more oxides of metals or metalloids of the 3rd main group, 4th main group and/or 4th transition group during compounding.

2. Use according to Claim 1, wherein the PMMI copolymer has 3% to 65% by weight of methyl methacrylate units, at least 30% by weight of methylmethacrylimide units, a total of up to 15% by weight of methylmethacrylic acid units and methylmethacrylic anhydride units, in each case based on the total weight of the PMMI copolymer, and an acid number, determined according to DIN 53240-1:2013-06, of 15 to 50 mg KOH/g.

3. Composition containing
A) aromatic polycarbonate,
B) one or more oxides of metals or metalloids of the 3rd main group, 4th main group and/or 4th transition group,
C) PMMI copolymer and
D) optionally further additives.

4. Composition according to Claim 3, wherein the composition contains
A) at least 55% by weight of aromatic polycarbonate,
B) 5% to 44% by weight of one or more oxides of metals or metalloids of the 3rd main group, 4th main group and/or 4th transition group,
C) 0.1% to 8% by weight of PMMI copolymer and
D) optionally further additives.

5. Composition according to Claim 3 or 4, wherein the composition contains
A) at least 56% by weight of aromatic polycarbonate,
B) 10% to 35% by weight of one or more oxides of metals or metalloids of the 3rd main group, 4th main group and/or 4th transition group,
C) 0.2% to 6% by weight of PMMI copolymer and
D) optionally further additives.

6. Composition according to any of Claims 3 to 5, consisting of
A) at least 60% by weight of aromatic polycarbonate,
B) 10% to 30% by weight of one or more oxides of metals or metalloids of the 3rd or 4th main group or 4th transition group,
C) 0.2% to 6% by weight of PMMI copolymer and
D) optionally one or more further additives distinct from components B and C selected from the group consisting of flame retardants, anti-drip agents, impact modifiers, fillers, antistats, colourants, pigments, carbon black, lubricants and/or demoulding agents, heat stabilizers, blend partners, compatibilizers, UV absorbers and/or IR absorbers.

7. Composition according to any of Claims 3 to 6, wherein the composition contains at least 1.5% by weight of PMMI copolymer, based on the overall composition.

8. Composition according to any of Claims 3 to 7, wherein the composition contains 15% to 25% by weight of one or more oxides of metals or metalloids of the 3rd main group, 4th main group and/or 4th transition group and at least 1.0% by weight of PMMI copolymer.

9. Composition according to any of Claims 3 to 8 or use according to Claim 1, wherein the PMMI copolymer has methyl methacrylate units, methylmethacrylimide units, methylmethacrylic acid units and methylmethacrylic anhydride units.

10. Composition according to any of Claims 3 to 9 or use according to Claim 1 or 9, wherein the proportion of methylmethacrylimide units is at least 30% by weight, the proportion of methyl methacrylate units is 3% to 65% by weight and the proportion of methylmethacrylic acid and methylmethacrylic anhydride units is in total up to 15% by weight in each case based on the total weight of the PMMI copolymer present in the composition.

11. Composition according to any of Claims 3 to 10 or use according to any of Claims 1, 9 and 10, wherein the acid number of the PMMI copolymer, determined according to DIN 53240-1:2013-06, is 15 to 50 mg KOH/g.

12. Composition according to any of Claims 3 to 11 or use according to any of Claims 1, 9, 10 and 11, wherein the proportion of oxides of metals or metalloids of the 3rd main group, 4th main group and/or 4th transition group is 15% to 25% by weight based on the total composition and the ratio of oxides of metals or metalloids of the 3rd main group, 4th main group and/or 4th transition group to PMMI copolymer is ≤ 40.

13. Composition according to any of Claims 3 to 12 or use according to any of Claims 1 or 9 to 12, wherein the proportion of PMMI copolymer in the finished composition is 2% to 6% by weight.

14. Moulding made from a or comprising regions of a composition according to any of Claims 3 to 13.

15. Moulding according to Claim 14, wherein the moulding is a profile, a plate, a housing part in the electricals/electronics sector, a heatsink, a reflector, a printed circuit board in the electronics sector, an element for an optical application, a composite.

## Revendications

1. Utilisation d'au moins un copolymère de polyméthacrylméthylimide (copolymère de PMMI) pour la réduction de la dégradation du poids moléculaire de polycarbonate aromatique dans des compositions de polycarbonate, contenant un ou plusieurs oxydes de métaux ou de semi-métaux du 3ème groupe principal, du 4ème groupe principal et/ou du 4ème groupe secondaire lors du mélange.

2. Utilisation selon la revendication 1, le copolymère de PMMI présentant 3 à 65% en poids de motifs de méthacrylate de méthyle, au moins 30% en poids de motifs de méthylméthacrylimide, au total jusqu'à 15% en poids de motifs d'acide méthylméthacrylique et de motifs d'anhydride méthylméthacrylique, à chaque fois par rapport au poids total du copolymère de PMMI et un indice d'acide, déterminé selon la norme DIN 53240-1:2013-06, de 15 à 50 mg de KOH/g.

3. Composition contenant
A) du polycarbonate aromatique,
B) un ou plusieurs oxydes de métaux ou de semi-métaux du 3ème groupe principal, du 4ème groupe principal et/ou du 4ème groupe secondaire,
C) un copolymère de PMMI et
D) éventuellement d'autres additifs.

4. Compositions selon la revendication 3, la composition contenant
A) au moins 55% en poids de polycarbonate aromatique,
B) 5 à 44% en poids d'un ou de plusieurs oxydes de métaux ou de semi-métaux du 3ème groupe principal, du 4ème groupe principal et/ou du 4ème groupe secondaire,
C) 0,1 à 8% en poids de copolymère de PMMI et
D) éventuellement d'autres additifs.

5. Compositions selon la revendication 3 ou 4, la composition contenant
A) au moins 56% en poids de polycarbonate aromatique,
B) 10 à 35% en poids d'un ou de plusieurs oxydes de métaux ou de semi-métaux du 3ème groupe principal, du 4ème groupe principal et/ou du 4ème groupe secondaire,
C) 0,2 à 6% en poids de copolymère de PMMI et
D) éventuellement d'autres additifs.

6. Composition selon l'une quelconque des revendications 3 à 5, constituée par
A) au moins 60% en poids de polycarbonate aromatique,
B) 10 à 30% en poids d'un ou de plusieurs oxydes de métaux ou de semi-métaux du 3ème ou du 4ème groupe principal ou du 4ème groupe secondaire,
C) 0,2 à 6% en poids de copolymère de PMMI et
D) éventuellement un ou plusieurs autres additifs différents des composants B et C, choisis dans le groupe constitué par les agents ignifuges, les agents antigoutte, les agents de modification de la résilience, les charges, les antistatiques, les colorants, les pigments, la suie, les agents lubrifiants et/ou de démoulage, les agents de thermostabilisation, les partenaires de mélange, les promoteurs de compatibilité, les absorbants des UV et/ou les absorbants des IR.

7. Composition selon l'une quelconque des revendications 3 à 6, la composition contenant au moins 1,5% en poids de copolymère de PMMI, par rapport à la composition totale.

8. Composition selon l'une quelconque des revendications 3 à 7, la composition contenant 15 à 25% en poids d'un ou de plusieurs oxydes de métaux ou de semi-métaux du 3ème groupe principal, du 4ème groupe principal et/ou du 4ème groupe secondaire et au moins 1,0% en poids de copolymère de PMMI.

9. Composition selon l'une quelconque des revendications 3 à 8 ou utilisation selon la revendication 1, le copolymère de PMMI présentant des motifs de méthacrylate de méthyle, les motifs de méthylméthacrylimide, des motifs d'acide méthylméthacrylique et des motifs d'anhydride méthylméthacrylique.

10. Composition selon l'une quelconque des revendications 3 à 9 ou utilisation selon la revendication 1 ou 9, la proportion de motifs de méthylméthacrylimide étant d'au moins 30% en poids, la proportion de motifs de méthacrylate de méthyle étant de 3 à 65% en poids et la proportion de motifs d'acide méthylméthacrylique et d'anhydride méthylméthacrylique étant au total de jusqu'à 15% en poids, à chaque fois par rapport au poids total du copolymère de PMMI contenu dans la composition.

11. Composition selon l'une quelconque des revendications 3 à 10 ou utilisation selon l'une quelconque des revendications 1, 9 ou 10, l'indice d'acide du copolymère de PMMI, déterminé selon la norme DIN 53240-1:2013-06, étant de 15 à 50 mg de KOH/g.

12. Composition selon l'une quelconque des revendications 3 à 11 ou utilisation selon l'une quelconque des revendications 1, 9, 10 ou 11, la proportion d'oxydes de métaux ou de semi-métaux du 3ème groupe principal, du 4ème groupe principal et/ou du 4ème groupe secondaire étant de 15 à 25% en poids, par rapport à la composition totale et le rapport des oxydes de métaux ou de semi-métaux du 3ème groupe principal, du 4ème groupe principal et/ou du 4ème groupe secondaire au copolymère de PMMI étant ≤ 40.

13. Composition selon l'une quelconque des revendications 3 à 12 ou utilisation selon l'une quelconque des revendications 1 ou 9 à 12, la proportion de copolymère de PMMI dans la composition finie étant de 2 à 6% en poids.

14. Pièce moulée constituée par une composition selon l'une quelconque des revendications 3 à 13 ou comprenant des zones constituées par celle-ci.

15. Pièce moulée selon la revendication 14, la Pièce moulée étant un profilé, une plaque, une partie de boîtier dans le domaine électrique/électronique, un dissipateur thermique, un réflecteur, une carte dans le domaine électronique, un élément pour une utilisation optique, un composite.
